# EUROPEAN PATENT APPLICATION

(11) **EP 1 667 274 A1**
(43) Date of publication of application: **07.06.2006**
(21) Application number: 04771391.2
(22) Date of filing: 03.08.2004
(51) Int. Cl.: H01M 14/00, H01L 31/04

(54) **PHOTOELECTRIC CONVERTER AND METHOD FOR MANUFACTURING SAME**

(30) Priority: 06.08.2003 JP 2003288076; 18.12.2003 JP 2003421084; 25.12.2003 JP 2003430606; 05.03.2004 JP 2004063032; 31.03.2004 JP 2004106616; 31.03.2004 JP 2004106617
(71) Applicant: FUJIKURA LTD., Kohtoh-ku, Tokyo 135-8512 (JP)
(72) Inventor: EZURE, Tetsuya c/o Fujikura Ltd., Kohtoh-ku, Tokyo 135-8512 (JP); TANABE, Nobuo c/o Fujikura Ltd., Kohtoh-ku, Tokyo 135-8512 (JP); MATSUI, Hiroshi c/o Fujikura Ltd., Kohtoh-ku, Tokyo 135-8512 (JP); OKADA, Kenichi c/o Fujikura Ltd., Kohtoh-ku, Tokyo 135-8512 (JP)
(74) Representative: Boire, Philippe Maxime Charles
(86) International application number: PCT/JP2004/011404
(87) International publication number: WO 2005/015678

(57) **Abstract**

A photoelectric conversion element, comprises: a casing; and a stacked body enclosed within the casing, wherein the stacked body comprises: a working electrode having a porous oxide semiconductor layer having a sensitizing dye supported on a surface thereof; a counter electrode provided on a side of the porous oxide semiconductor layer of the working electrode facing the working electrode; and an electrolyte layer disposed on at least a part of which is between the working electrode and the counter electrode, and wherein an upper surface and a lower surface of the stacked body contacts directly or indirectly an inner surface of the casing, the portion of the casing at least contacting the working electrode being made of a material having an optical characteristic of transmitting sunlight.

## Description

Priority is claimed on Japanese Patent Application No. 2003-288076 filed August 6, 2003; Japanese Patent Application No. 2003-421084 filed December 18, 2003; Jàpanese Patent Application No. 2003-430606 filed December 25, 2003; Japanese Patent Application No. 2004-63032 filed March 5, 2004; Japanese Patent Application No. 2004-106616, filed March 31, 2004; and Japanese Patent Application No. 2004-106617 filed March 31, 2004, the contents of which are incorporated herein by reference.

### TECHNICAL FIELD

The present invention relates to a photoelectric conversion element, such as a dye-sensitized solar cell, and a method for manufacturing the same. More specifically, the present invention relates to a photoelectric conversion element in which a cell constituting member and a packaging material provided outside the cell constituting member can be sealed as a whole without applying any load, such as application of heat, on a cell having a stacked body formed by sandwiching an electrolyte layer between a working electrode and a counter electrode; a method for manufacturing the same; and a photoelectric conversion element having a plurality of stacked bodies, each of the stacked body being formed by sandwiching an electrolyte between a working electrode and counter electrode so that they are stacked together, which are enclosed within a sealed casing.

### BACKGROUND ART

Solar cells have been attracting attention as clean energy sources against the background of environmental problems and resource problems. There is one type of solar cell that employs monocrystalline, polycrystalline or amorphous silicon. However conventional silicon-based solar cells have not been in common use since there are problems to be solved, such as expensive manufacturing costs and insufficient supply of raw materials.

Furthermore, compound solar cells, such as ones using Cu-In-Se (they are referred to as "CIS"), have been developed, and such compound solar cells have excellent characteristics, such as having an extremely high conversion efficiency. However; such compound solar cells have not become widespread due to problems, such as costs and environmental load.

In relation to these solar cells, dye-sensitized solar cells proposed by a group consisting of Graetzel and others in Switzerland have been attracting attention as photoelectric conversion elements that are inexpensive and can provide high photoelectric conversion efficiencies.

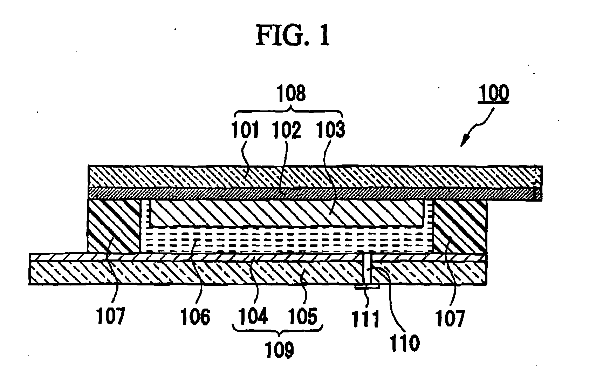

FIG. 1 is a schematic cross-sectional view illustrating an example of a dye-sensitized solar cell according to conventional art.

This dye-sensitized solar cell 100 generally includes a fim substrate 101 having a porous semiconductor electrode (hereinafter, referred to as a "dye-sensitized semiconductor electrode") 103 having a sensitizing dye supported on one surface thereof, a second substrate 105 having a conductive film 104 formed thereon, and an electrolyte layer 106 made of a gel electrolyte, for example, sealed therebetween.

The first substrate 101 is made of a plate material having light transparency, and a transparent conductive layer 102 is provided on the surface of the first substrate 101 that contacts the dye-sensitized semiconductor electrode 103 in order to impart conductivity. The first substrate 101, the transparent conductive layer 102, and the dye-sensitized semiconductor electrode 103 constitute a window electrode 108.

A conductive layer 104 made of carbon or platinum, for example, is provided in order to impart conductivity on the surface of the second substrate 105 that contact the electrolyte layer 106. The second substrate 105 and the conductive layer 104 constitute a counter electrode 109.

In the dye-sensitized solar cell 100, the first substrate 101 and the second substrate 105 are disposed with a predetermined spacing between them so that the dye-sensitized semiconductor electrode 103 and the conductive layer 104 face each other, and a sealing material 107 made of a thermoplastic resin is provided on the periphery portion of the two substrates. The two substrates 101 and 105 are bonded to each other via the sealing material 107 to assemble a cell, and an organic electrolyte solution containing oxidized / reduced species, such as iodine / iodide ions, is filled between the two electrodes 108 and 100 via an inlet 110 for the electrolyte solution to form the electrolyte layer 106 for charge transfer. In other words, the sealing material 107 plays the role of preventing leakage or volatilization of volatile constituents of the electrolyte solution contained in the electrolyte layer 106.

Next, a summary of a method for manufacturing the dye-sensitized solar cell 100 will be explained.

First, after the window electrode 108 and the counter electrode 109 are stacked together via the sealing material 107 made of a thermoplastic resin, the sealing material 107 is heated via the window electrode 108 and the counter electrode 109, or either one of the window electrode 108 and the counter electrode 109 to melt the sealing material 107, thereby bonding the window electrode 108 and the counter electrode 109 together. Thus, a stacked body made of a pair of electrodes (the window electrode 108 and the counter electrode 109) is assembled. Next, after the organic electrolyte solution containing oxidized / reduced species, such as iodine / iodide ions, is filled between the window electrode 108 and the counter electrode 109 through the inlet 110 that is provided so as to penetrate the counter electrode 109, the inlet 110 is sealed using a cap 111 to form the electrolyte layer 106 for charge transfer, thereby obtaining the dye-sensitized solar cell 100 having a pair of electrodes (the window electrode 108 and the counter electrode 109) and the electrolyte layer 106 provided sandwiched between them (see Japanese Unexamined Patent Application, First Publication No. 2002-184478 and N. Papageorgiu et al., J. Electrochem. Soc., 143 (10), 3099,1996, for example).

For injecting the electrolyte solution, after assembling the cell of the solar cell, the electrolyte solution is injected through a liquid injecting inlet provided on the backside in a batch manner employing capillary action, pressure difference, or the like.

By making the semiconductor electrode as a porous film structure having a large specific surface area with a roughness factor of more than 1000, the photo absorption efficiency can be increased and even photoelectric conversion efficiencies of 10% or more have been reported. The cost is expected to be about one half to one sixth of conventional silicon-based solar cells. Since complex and large manufacturing facilities are not necessarily required and such solar cells do not contain any harmful substances, they have a high potential for being inexpensively mass-produced solar cells that are capable of coming into wide use.

However, the above-described dye-sensitized solar cell has a problem in that a volatile solvent, such as acetonitrile, is used in the electrolyte solution that is scaled in the cell and the cell performances may be deteriorated due to volatilization in such a system. In order to solve this problem, attempts have been made to use an ionic liquid as an electrolyte solution (see N. Papageorgiu et al., J. Electrochem. Soc., 143 (10), 3099,1996, for example). Such an ionic liquid is also called a room temperature molten salt, is present as a stable liquid in a broad temperature region, including in the vicinity of room temperature, and is a salt made from ions having positive and negative charges. Since these ionic liquids have substantially no vapor pressure and do not vaporize at room temperature, they are not liable to volatilization or ignition, unlike typical organic solvents. Thus, they are expected to become a solution to the problem of a decrease in cell performances caused by volatilization.

Furthermore, since an electrolyte solution, when used, may leak during the manufacturing processes or upon breakage of the cell, attempts have been made by various research institutions in order to make the electrolyte solution into a gel (quasi-solid) using an appropriate gelling reagent (for example, Japanese Unexamined Patent Application, First Publication No. 2002-184478). There are some reports that the volatility of an electrolyte solution can be reduced when it is made into a gel when compared with a liquid state. Similar attempts have been made for ionic liquids, and ionic liquids that are made into a gel (ion gel) have characteristics of excellent safety and durability.

However, upon manufacturing the above-described conventional dye-sensitized solar cell, the sealing material 107 is formed by sealing with a thermoplastic resin. More specifically, as shown in FIG. 1, heat is applied to melt the resin so that the two electrodes (the window electrode 108 and the counter electrode 109) are bonded together. During this process, heat may be conducted to the dye-sensitized semiconductor electrode 103 via the first substrate 101, which may adversely affect the dye absorbed on the dye-sensitized semiconductor electrode 103.

In addition, since the sealing material 107 is made of a resin, it may suffer from the problem of a deterioration of weather resistance when used for a long time.

Furthermore, upon injecting the electrolyte solution, the electrolyte solution must be injected through a pre-formed inlet 110 between the two electrodes that define a very narrow space after the two electrode plates are bonded together to define the shape of the cell. Finally, the cap 111 must be placed in the inlet 110. As a result, the manufacturing processes become complicated.

In addition, if the viscosity of the electrolyte solution is high, much time aid labor are required to inject the electrolyte solution, which incurs an increase in the manufacturing cost. In addition, since the sealing material 107 is made of a thermoplastic resin, it may suffer from the problem of low weather resistance and it may not be suitable for long-term use.

### DISCLOSURE OF INVENTION

A first aspect of the present invention was conceived in view of the above-described background, and an object thereof is to provide a photoelectric conversion element in which the influence on the dye absorbed on the dye-sensitized semiconductor electrode caused by the heat applied when the electrodes are bonded together is reduced, excellent weather resistance when used for a long time is provided, and the injection of the liquid or gel electrolyte solution is facilitated, and a method for manufacturing the same,

A first aspect of the present invention provides a photoelectric conversion element, comprising: a casing; and a stacked body enclosed within the casing, wherein the stacked body comprises: a working electrode having a porous oxide semiconductor layer having a sensitizing dye supported on a surface thereof; a counter electrode provided on a side of the porous oxide semiconductor layer of the working electrode facing the working electrode; and an electrolyte layer disposed on at least a part of which is between the working electrode and the counter electrode, and wherein an upper surface and a lower surface of the stacked body directly or indirectly contacts an inner surface of the casing, the portion of the casing at least contacting the working electrode being made of a material having an optical characteristic of transmitting sunlight.

In the above-described photoelectric conversion element, the stacked body formed by sandwiching the electrolyte layer between the working electrode and the counter electrode is enclosed such that the upper and lower surfaces thereof directly or indirectly contact the inner surface of the casing. In other words, by employing the structure in which the inner surfaces of the casing sandwich the upper and lower surfaces of the stacked body directly or indirectly, since it is possible to seal as a whole the cell constituting member that is made of the stacked body by sealing the casing, the influence of the heat applied ion the stacked body can be significantly reduced. Accordingly, since the problem of the prior art in that certain functions of the dye are inhibited due to the influence of the heat applied upon bonding the electrodes is solved and the dye exhibits stable characteristics, it is possible to obtain stable photoelectric conversion characteristics. Furthermore, when the portion of the casing at least contacting the working electrode being made of a material having an optical characteristic of transmitting sunlight, it is possible to let incident sunlight into the cell constituting member that is made of the stacked body.

Furthermore, in the photoelectric conversion element having such a structure, since a stacked body formed by sandwiching an electrolyte layer between a working electrode and a counter electrode can be utilized, the stacked body that is formed by sandwiching the electrolyte layer between the working electrode and the counter electrode is formed by placing one of the electrodes on the other electrode after dropping, applying, or spraying a liquid or gel electrolyte on the other electrode, and applying a pressure to infiltrate the liquid or gel electrolyte on the porous oxide semiconductor layer forming the working electrode of the electrodes, thereby forming the electrolyte layer. In this process, the liquid or gel electrolyte solution sandwiched between the electrodes does not leak from the spacing between electrodes due to capillary action. Accordingly, since it is possible to omit the injection step of an electrolyte solution, which conventionally required much time, the cost required for manufacturing photoelectric conversion elements can be reduced even further.

Furthermore, according to the above-described structure, a sealing material made of a resin is not required, unlike the conventional technique. Thus, since the weather resistance when used for a long time is improved, it is possible to provide a photoelectric conversion element having an excellent long-term stability of the photoelectric conversion characteristics.

Furthermore, in the above-described photoelectric conversion element, a configuration is employed in which the cell constituting member that is made of the stacked body is placed within the casing and insulated from the outside air. That is, since the cell constituting member is enclosed within the sealed space, it is possible to obtain a photoelectric conversion element having better anti-environment characteristics than conventional photoelectric conversion elements.

In the above-described photoelectric conversion element, by providing an elastic member between the counter electrode and the casing, the stacked body formed by sandwiching an electrolyte layer between the working electrode and the counter electrode is kept within the casing while being vertically and strongly pressed by the repellent force of the elastic member. Accordingly, since the upper and lower electrodes are resistant to the relative positional displacement in the direction of the surface thereof, it is possible to provide a photoelectric conversion element having a high shape stability against an external force and an excellent shock resistance.

In the above-described photoelectric conversion element, when a configuration is employed in which conductive bodies are provided such that they are routed within the casing without contacting the side surface of the stacked body and one end of each of the conductive bodies is connected to the counter electrode and the working electrode, respectively, and the other ends extend outside the casing, it is possible to freely lead the other ends of the conductive bodies used for connecting to the external circuit from any location of the casing. Accordingly, the photoelectric conversion element according to the first aspect of the present invention having the cell constituting member that is made of the stacked body within the casing can meet various requirements for installation according to the external circuit system.

As a preferable example of the other ends of the conductive bodies, a structure in which they extend from the side surface of the casing to the outside of the casing is exemplified. According to such a structure, since connecting a plurality of photoelectric conversion elements in series is simply achieved by arranging the casings two-dimensionally so that the side surfaces of the casings contact each other, it is possible to significantly shorten the time required for installation. Especially, unlike the conventional technique, since no circuit for connecting between photoelectric conversion elements is required, it is possible to manufacture the unit at low cost.

As another preferable example of the other ends of the conductive bodies, a structure in which they extend from the bottom portion of the casing to the outside of the casing is exemplified. According to such a structure, since connecting a plurality of photoelectric conversion elements in series is simply achieved by arranging the casings two-dimensionally so that the bottom portion of the casing contacts the external circuit, it is possible to significantly shorten the time required for installation. Especially, since the external circuit for connecting between photoelectric conversion elements is laid on the bottom of the casing, the external circuit is protected by the casing enclosing the photoelectric conversion elements. Thus, it is possible to further improve the anti-environment characteristics.

The photoelectric conversion element having such a form can be employed as a part of or an entire roof material or wall material, for example.

The first aspect of the present invention provides a method for manufacturing a photoelectric conversion element, comprising the steps of: providing a casing comprising a housing body having an inner bottom surface and a lid body; providing a working electrode having a porous oxide semiconductor layer having a sensitizing dye supported on a surface thereof; forming an electrolyte layer by filling a liquid or gel electrolyte on the porous oxide semiconductor layer of the working electrode; placing the counter electrode on the inner bottom surface of the housing body of the casing; overlaying the working electrode on the counter electrode so that the counter electrode contacts the electrolyte layer to form a stacked body; placing the lid body of the casing on the working electrode over the working electrode; and applying a load in a direction orthogonal to the surface of the stacked body from an outside of the stacked body to seal the casing.

In the above-described method for manufacturing, with the step of forming an electrolyte layer by filling a liquid or gel electrolyte on the porous oxide semiconductor layer constituting the working electrode, it is possible to distribute the liquid or gel electrolyte evenly on the surface of the porous oxide semiconductor layer.

As used herein, "filling the liquid or gel electrolyte on the porous oxide semiconductor layer constituting the working electrode" includes infiltrating the liquid or gel electrolyte onto the surface of the porous oxide semiconductor layer. Furthermore, the "liquid electrolyte" usually refers to an electrolyte that is generally referred to as an electrolyte solution, and refers to a solution in which electrolyte components, such as iodine / iodide ions, are dissolved in a solvent.

For example, a stacked body that is formed by sandwiching the electrolyte layer between the working electrode and the counter electrode is formed by placing one of the electrodes on the other electrode after dropping, applying, or spraying a liquid or gel electrolyte on the other electrode, and applying a pressure to infiltrate the liquid or gel electrolyte on the porous oxide semiconductor layer forming the working electrodes of the electrodes, thereby forming the electrolyte layer.

That is, according to this step, unlike the conventional technique, since no liquid or gel electrolyte is required to be forcefully injected into a narrow space between the working electrode and the counter electrode through an inlet, it is possible to solve problems such as no liquid or gel electrolyte being distributed to some areas between the working electrode and the counter electrode or the liquid or gel electrolyte being distributed unevenly.

Furthermore, with the steps of overlaying the working electrode on the counter electrode so that the counter electrode contacts the electrolyte layer to form a stacked body to form the stacked body; placing the working electrode over the casing; and then applying a load in a direction orthogonal to the surface of the stacked body from an outside of the stacked body to seal the casing, it is possible to seal as a whole the cell constituting member that is made of the stacked body by sealing the casing. Even when heat is applied locally to the casing upon sealing of the casing, substantially no heat is applied to the stacked body. Accordingly, by employing these steps, it is possible to solve the problem of the conventional technique in which certain functions of the dye are inhibited due to the influence of the heat applied upon bonding the electrodes.

Accordingly, the manufacturing method according to the first aspect of the present invention provides a photoelectric conversion element having the above-described features. That is, it contributes to stable manufacturing of a photoelectric conversion element in which the influence on the dye absorbed on the dye-sensitized semiconductor electrode caused by the heat applied when the electrodes are bonded together is reduced, excellent weather resistance when used for a long time is provided, and the injection of the liquid or gel electrolyte solution is facilitated.

A second aspect of the present invention was conceived in view of the above-mentioned background, and an object thereof is to provide a photoelectric conversion element having an excellent power generation efficiency to which an electrolyte solution can be injected by dropping it and a method for manufacturing the same.

A second aspect of the present invention provides a photoelectric conversion element, comprising: a housing body having an inner bottom surface; and a stacked body, wherein the stacked body comprises: a working electrode having a porous oxide semiconductor layer having a sensitizing dye supported on a surface thereof; a counter electrode provided on a side of the porous oxide semiconductor layer of the working electrode facing the working electrode; and an electrolyte layer disposed on at least a part of which is between the working electrode and the counter electrode, and wherein the stacked body is enclosed within the housing body so that the counter electrode directly or indirectly contacts the inner bottom surface of the housing body, and the housing body is sealed using the working electrode.

In the photoelectric conversion element having such a structure, the stacked body formed by sandwiching the electrolyte layer between the working electrode and the counter electrode is enclosed such that the counter electrode directly or indirectly contacts the inner bottom surface and the housing body is sealed using the working electrode. In other words, the working electrode functions as the lid body constituting the casing.

In the photoelectric conversion element employing this structure, since it is possible to utilize the stacked body that is formed by sandwiching the electrolyte layer between the working electrode and the counter electrode, a liquid or gel electrolyte can be filled on one of the electrodes and the other electrode can be placed thereon, whereby forming the stacked body, for example. In this process, the electrolyte solution sandwiched between the electrodes does not leak from the spacing between the electrodes due to capillary action. Accordingly, since it is possible to omit the injection step of an electrolyte solution, which conventionally required much time, the cost required for manufacturing photoelectric conversion elements can be reduced even further.

In the above-described photoelectric conversion element, as the first substrate constituting the working electrode, a material having both an optical characteristic to transmit sunlight and a resistance to heat is preferred. The optical characteristic to transmit sunlight allows sunlight to reach the stacked body enclosed within the casing. Furthermore, since the resistance to heat prevents generation of curling or the like due to the influence of heat applied upon sealing and assures the inter-electrode distance, the long-term stability of the power generation characteristic is assured.

A second aspect of the present invention provides a method for manufacturing a photoelectric conversion element, comprising the steps of: providing a casing comprising a housing body having an inner bottom surface; providing a working electrode having a porous oxide semiconductor layer having a sensitizing dye supported on a surface thereof; forming an electrolyte layer by filling a liquid or gel electrolyte on the porous oxide semiconductor layer of the working electrode; placing the counter electrode on the inner bottom surface of the housing body of the casing so that the counter electrode directly or indirectly contacts the inner bottom surface of the housing body; overlaying the working electrode on the counter electrode so that the counter electrode contacts the electrolyte layer to form a stacked body; placing the working electrode over the casing, and sealing the working electrode to the housing body using a laser method or an adhesion method to fabricate the casing.

The above manufacturing method particularly includes the steps of directly or indirectly providing the counter electrode on the inner bottom surface of the housing body constituting the casing; overlaying the working electrode on the counter electrode so that the counter electrode contacts the electrolyte layer to form a stacked body; placing the working electrode so that it functions as the lid body of the casing; and sealing the working electrode to the housing body using a laser method or an adhesion method to fabricate the casing, Thus, it is possible to easily perform the sealing by radiating a laser on (referred to as a laser method) or providing an adhesive (referred to as an adhesion method) to the portion to be sealed without using conventionally used resins. In other words, the sealing is performed by radiating a laser on or bonding only the connecting portion between the lid body and the housing body in the manufacturing method according to the second aspect of the present invention. Thus, without applying any load, such as application of heat, on a cell, ie., the stacked body, unlike conventional sealing methods, it is possible to seal the casing as a whole by enclosing the stacked body that forms the cell within the housing body constituting the casing and providing the lid body thereon. Furthermore, this is preferred since occurrence of problems caused by the flow of the resin for sealing can be prevented.

A third aspect of the present invention was conceived in view of the above-described background, and an object thereof is to provide a photoelectric conversion element that provides an excellent power generation efficiency, reduces the variation in the power generation efficiency, and has substantially no variation of the power generation efficiency across the entire surface of the light-receiving surface of the photoelectric conversion element.

The third aspect of the present invention provides a photoelectric conversion element, comprising: a casing; and a plurality of stacked bodies, wherein the plurality of stacked bodies are sealed within the casing while being arranged, and each of the stacked bodies comprises: a working electrode; a counter electrode; and an electrolyte layer sandwiched between the working electrode and the counter electrode, wherein the casing comprises a back plate; and a frame body provided on an outer periphery portion of the back plate, wherein the frame body comprises a side wall portion and a window frame portion, and the window frame portion is provided facing the back plate and presses the stacked body in a direction of the back plate, and wherein the stacked body comprises a current collecting wiring portion, and the window frame portion is provided in a region corresponding to a position of the current collecting wiring portion of the stacked body.

The invention according to the third aspect of the present invention is characterized in that the side wall portion is detachable from the back plate, or that the window frame portion is detachable from the side wall portion.

The invention according to third aspect of the present invention is characterized in that an elastic member is provided between the stacked body and the back plate.

A fourth aspect of the present invention was conceived in view of the above-described background, and an object thereof is to provide a photoelectric conversion element that can be manufactured inexpensively, has an excellent long-term reliability and power generation efficiency, and can be easily repaired or replaced when problems occur.

In order to solve the above-described problems, the fourth aspect of the present invention provides a photoelectric conversion element, comprising; a stacked bodys and a casing that encloses the stacked body, wherein the stacked body comprises: a working electrode; a counter electrode; and an electrolyte layer formed between the working electrode and the counter electrode, wherein the casing comprises a frame body that covers the stacked body and a lid body that fixes the stacked body to the frame body, and the frame body covers a region of the working electrode corresponding to a position where the conductive body is formed.

In the above-described photoelectric conversion element, it is preferable that the conductive body be provided on a periphery of the working electrode.

In the above-described photoelectric conversion element, it is preferable that the lid body be detachably secured to the frame body.

In the above-described photoelectric conversion element, it is preferable that an elastic member be inserted between the counter electrode and the lid body.

A fifth aspect of the present invention was conceived in view of the above-described background, and an object thereof is to provide a photoelectric conversion element that can be manufactured inexpensively, has an excellent long-term reliability and power generation efficiency, and can be easily repaired or replaced when problems occur.

In order to solve the above-described problems, the fifth aspect of the present invention provides a photoelectric conversion element, comprising: a stacked body, and a casing that encloses the stacked body, wherein the stacked body comprises: a working electrode; a counter electrode; and an electrolyte layer formed between the working electrode and the counter electrode, wherein the casing comprises a main body that covers the stacked body and a lid body that fixes the stacked body to the main body, and the lid body is detachably secured to the main body.

The fifth aspect of the present invention provides a photoelectric conversion element, comprising: a stacked body; and a casing that encloses the stacked body, wherein the stacked body comprises: a working electrode; a counter electrode; and an electrolyte layer formed between the working electrode and the counter electrode, wherein the casing is made of a main body that covers the stacked body, and the working electrode is detachably secured to the main body.

In the above-described photoelectric conversion element, it is preferable that an elastic member be inserted between the counter electrode and the casing.

### BRIEF DESCRIPTION OF THE DRAWINGS

FIG. 1 is a cross-sectional view illustrating an example of a dye-sensitized isolar cell according to conventional art
FIG. 2 is a cross-sectional view illustrating an example of a photoelectric conversion element according to a first embodiment of the present invention.
FIG. 3 is a cross-sectional view illustrating another example of the photoelectric conversion element according to the first embodiment of the present invention.
FIG. 4 is a cross-sectional view illustrating an example of the photoelectric conversion element according to the first embodiment of the present invention.
FIG. 5 is a cross-sectional view illustrating an example of a photoelectric conversion element according to a second embodiment of the present invention.
FIG. 6 is a plan view illustrating a dye-sensitized solar cell that is an example of a photoelectric conversion element according to a third embodiment of the present invention.
FIG. 7 is a cross-sectional view taken along Line A-A in FIG. 6.
FIG. 8 is a cross-sectional view illustrating another example of the dye-sensitized solar cell according to the third embodiment of the present invention.
FIG. 9 is a cross-sectional view illustrating a further example of the dye-sensitized solar cell according to the third embodiment of the present invention.
FIG. 10 is a schematic cross-sectional view illustrating a dye-sensitized solar cell that is a first example of a photoelectric conversion element according to a fourth embodiment of the present invention.
FIG. 11 is a schematic plan view illustrating the dye-sensitized solar cell shown in FIG. 10.
FIG. 12 is a schematic cross-sectional view illustrating a dye-sensitized solar cell that is a second example of a photoelectric conversion element according to the fourth embodiment of the present invention.
FIG. 13 is a schematic cross-sectional view illustrating a dye-sensitized solar cell that is a first example of a photoelectric conversion element according to a fifth embodiment of the present invention.
FIG. 14 is a schematic cross-sectional view illustrating a dye-sensitized solar cell that is a second example of a photoelectric conversion element according to the fifth embodiment of the present invention.

### BEST MODE FOR CARRYING OUT THE INVENTION

Preferred embodiments of the invention will be described with reference to the drawings. However, it should not be construed that the present invention is limited to those embodiments; rather, components of those embodiments, for example, may be combined if necessary.

### First Embodiment

A first embodiment of the present invention will be described in detail based on examples.

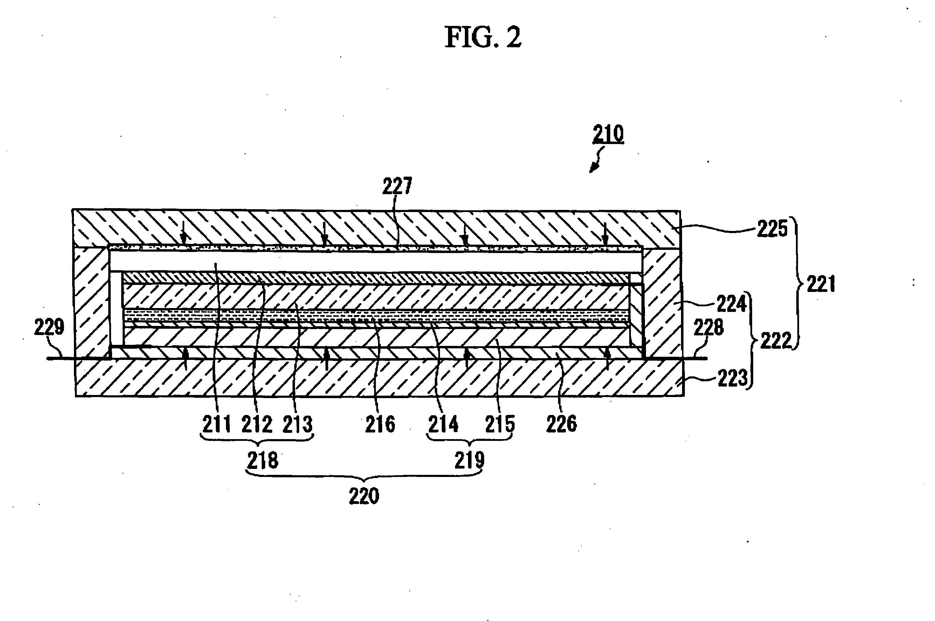

FIG. 2 is a schematic cross-sectional view illustrating an example of a photoelectric conversion element according to a first embodiment of the present invention.

A dye-sensitized solar cell (photoelectric conversion element) 210 includes a working electrode (also referred to as a window electrode) 218 having a porous oxide semiconductor layer (also referred to as an oxide electrode) 213 having a sensitizing dye supported on the surface thereof, a counter electrode 219 provided on the porous oxide semiconductor layer 213 side of the working electrode 218 facing to the porous oxide semiconductor layer 213, and an electrolyte layer 216 at least a part of which is between the two electrodes. The working electrode 218 includes, for example, a first substrate 211 and a transparent conductive film 212 and an oxide electrode 213 provided there above in this order. The opposing counter electrode 219 includes, for example, a second substrate 215 and a conductive film 214 disposed thereabove.

A stacked body 220 that is composed of the working electrode 218, the counter electrode 219, and the electrolyte layer 216 sandwiched therebetween functions as a cell constituting member, i.e., a photoelectric conversion element. In the dye-sensitized solar cell 210, the stacked body 220 is enclosed within a casing 221 surrounding therearound, and the upper and lower surfaces of the stacked body 220 contact the inner surface of the casing 221. Here, the portion of the casing 221 that at least partially contacts the working electrode 218, i.e., a lid body 225 shown in FIG. 2 is made of a material having an optical characteristic of transmitting sunlight.

In the dye-sensitized solar cell 210, the stacked body 220 that is formed by sandwiching the electrolyte layer 216 between the working electrode 218 and the counter electrode 219 is received (placed?) so that the upper and lower surfaces thereof contact the inner surface of the casing 221 and the inner surface of the casing 221 sandwiches the upper and lower surfaces of the stacked body 220. Accordingly, when the casing 221 is sealed where the lid body 225 contacts a side portion 224 of a housing body 222, for example, it is possible to seal as a whole the cell constituting member made of the stacked body 220.

It should be noted that the arrows directing to the stacked body 220 shown in FIG. 2 indicate the direction of force applied to the stacked body 220 when the casing 221 is sealed. It is preferable that an elastic member 226 be provided between the counter electrode 219 and a bottom portion 223 that constitutes the casing 221 in order to prevent an occurrence of a lateral displacement in the stacked body 220 or to seal the stacked body 220 so that the stacked body 220 is securely fixed while maintaining flexibility in the vertical direction when an external force is applied to the stacked body 220 in such a direction.

Furthermore, a space filler 227 is inserted between the working electrode 218 and the lid body 225 that constitutes the casing for a similar reason. It should be noted that a material having an excellent characteristic of transparency to sunlight may be preferably used for the space filler 227, as is apparent from the fact that the space filler 227 is placed on the working electrode 218. In addition, it is desirable to use silicone oil as the space filler 227 since an air layer present between the first substrate 211 and the lid body 225 can be removed, thereby improving the transparency.

The provision of the elastic member 226 or the space filler 227 is desirable since the upper and lower electrodes reduce the relative positional displacement in the direction of the surface thereof, the shape stability against an external force is improved, and shock resistance is provided.

Furthermore, in the dye-sensitized solar cell 210, conductive bodies 228 and 229 are provided such that they are routed within the casing 221 without contacting the side surface of the stacked body 220 and one end of each of the conductive bodies is connected to the counter electrode 219 and the working electrode 218, respectively, and the other ends extend outside the casing 221.

In this structure, it is possible to meet various installation requirements according to an external circuit system since the other ends of the conductive bodies 228 and 229 used for connecting to the external circuit that is not shown can be led flexibly outside the casing 221 from anywhere.

As for the conductive body 228 in which the one end thereof is connected to the working electrode 218 and the other end extends outside the casing 221, it may be provided in a manner in which the above-described elastic member 226 is inserted between the side surface of the stacked body 220 and the conductive body 228, as shown in FIG. 2, for example, so that it is routed within the casing 221 without contacting the side surface of the stacked body 220. Although an example in which the conductive body 228 is disposed being inserted between the elastic member 226 and the side portion 224 of the casing 221 is shown in FIG. 2, the conductive body 228 may be provided so as to penetrate through the elastic member 226.

The conductive bodies 228 and 229 shown in FIG. 2 are constructed such that the respective other end extends outside the casing 221 from the side portion 224 of the casing. When this structure is employed, it is possible to connect a plurality of photoelectric conversion elements in series by arranging them two-dimensionally such that the side surfaces of casings each contain a respective photoelectric conversion element. Since no connecting members or connecting circuits are needed which are conventionally required to connect photoelectric conversion elements and a connection can be achieved by simply arranging casings, a photoelectric conversion element according to the first embodiment of the present invention can significantly shorten the time required for installation. Furthermore, since connecting members or connecting circuits for connecting photoelectric conversion elements can be omitted, it becomes possible to manufacture units at low cost. A photoelectric conversion element that is formed using transparent members for all the casing sandwiching the stacked body can be used as an alternative to a glass window.

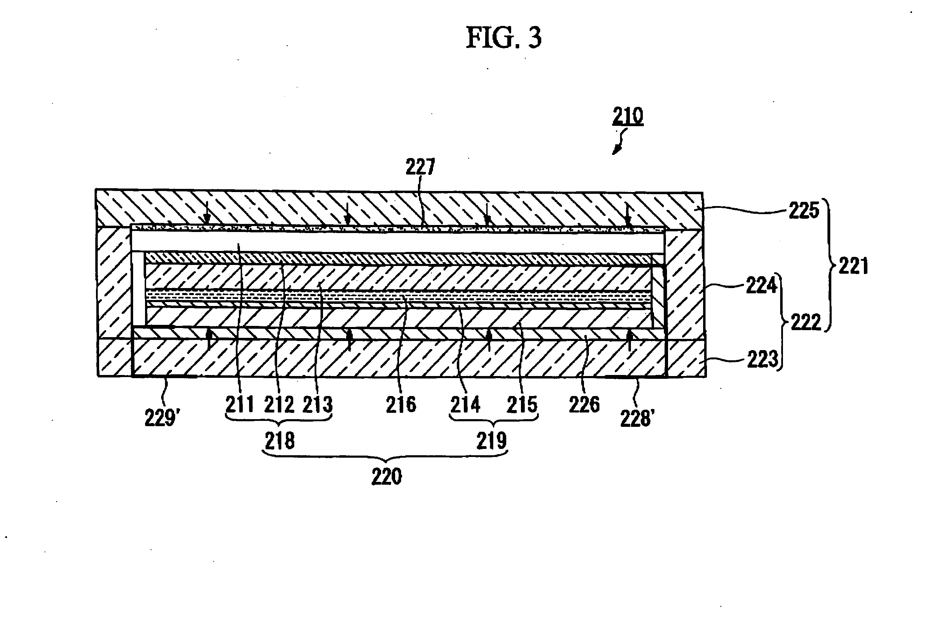

FIG. 3 is a schematic cross-sectional view illustrating another example of a photoelectric conversion element according to the first embodiment of the present invention. A photoelectric conversion element 210 shown in FIG. 3 is similar to the photoelectric conversion element 210 shown in FIG. 2 except for the fact that other ends of the conductive bodies 228' and 229' are each constructed to extend outside the casing 221 from the bottom portion 223 of the casing 221. When this structure is employed, it is possible to connect a plurality of photoelectric conversion elements in series by arranging casings 221 two-dimensionally such that the bottom portions 223 of the casings 221 contact an external circuit. Since no connecting members or connecting circuits are needed which are conventionally required to connect photoelectric conversion elements and photoelectric conversion elements can be connected to each other by simply placing connections to the conductive bodies 228' and 229' on the side on which the casings are installed, photoelectric conversion element according to the first embodiment of the present invention can significantly shorten the time required for installation, Furthermore, since connecting members or connecting circuits for connecting photoelectric conversion elements can be omitted, it becomes possible to manufacture units at low cost. Since the photoelectric conversion element having this structure can be handled as a roof tile or tile, it can be used as a part of or an entire roof material or wall material, for example.

As the first substrate 211 according to the first embodiment of the present invention, a plate made of a light transparent material is used and anything that is generally used as a transparent substrate of a solar cell may be used, such as one made of glass, polyethylene terephthalate, polyethylene naphthalate, a polycarbonate, a polyether sulfone, and the like. Although an appropriate one may be selected considering resistance to the liquid or gel electrolyte, a substrate having as high a light transparency as possible for its application is preferred.

It is preferable that the dye-sensitized semiconductor electrode 213 side of the first substrate 211 is imparted with conductivity by forming the transparent conductive film 212 made of a layer of metal, carbon, conductive metal oxide, or the like. When a metal layer or a carbon layer is formed as the transparent conductive film 212, it is preferable that a structure that does not significantly reduce the transparency be used and a proper type of metal is selected from the viewpoint of its capability of forming a thin film without reducing the conductivity. As a conductive metal oxide, ITO, SnO₂, fluorine-doped SnO₂, or the like, may be used, for example.

The dye-sensitized semiconductor electrode 213 that is formed by providing the sensitizing dye supported on semiconductor porous film is provided on the transparent conductive layer 212 formed on the first substrate 211. The first substrate 211, the transparent conductive layer 212, and the dye-sensitized semiconductor electrode 213 constitute a working electrode (window electrode) 218. The semiconductor for forming the semiconductor porous film of the dye-sensitized semiconductor electrode 213 is not particularly limited, and anything that can be used to form a porous semiconductor for a solar cell may be used. TiO₂, SnO₂, WO₃, ZnO, Nb₂O₅ or the like, may be used. Therporous film may be formed using methods, including, but not limited to, film formation with sol-gel method, electrophoretic-deposition of fine particles, formation of a porous film using foaming agents, coating with a mixture of polymer beads or the like followed by removal of the excess component.

The sensitizing dye is not particularly limited, and it is possible to use ruthenium complexes containing a ligand having bipyridine structures, terpyridine structures, and the like; metal containing complexes such as porphyrin and phthalocyanine; as well as organic dyes such as eosin, rhodamine, and merocyanine. Any dye can be selected without limitation according to the application and the excitation behavior appropriate for the semiconductor used.

Since the second substrate 215 does not necessarily have light transparency, a metal plate may be used, or a plate similar to the plate of the first substrate 211 may be used. An electrode having the conductive film 214 formed on the second substrate 215 is used as the counter electrode 219. As the conductive film 214, although a layer of carbon, platinum, or the like, that is formed by evaporation methods, sputtering methods, or methods in which after applying chloroplatinate, a heat treatment is conducted, may be preferably used, the film is not particularly limited as long as it can function as an electrode.

The electrolyte layer 216 is formed between the above-described working electrode 218 and the counter electrode 219 to form the cell constituting member made of the stacked body 220. The stacked body 220 according to the first embodiment of the present invention is formed by placing the working electrode 218 on the counter electrode 219 such that the working electrode 218 contacts a liquid or gel electrolyte after dropping, applying, or spraying the liquid or gel electrolyte on the porous oxide semiconductor layer 213 constituting the working electrode 218, and applying a load in the direction orthogonal to the surface of the stacked body, as described later.

Thus, since even materials having a high viscosity which are conventionally difficult to inject from an inlet to a narrow space between the electrodes may be used as the electrolyte layer 216 of the first embodiment of the present invention, high-viscosity 5 materials that are made into a gel (quasi-solidified) using an appropriate gelling reagent, such as a gel electrolyte, may be used. However, any material that is conventionally used may be used.

As the material for forming the electrolyte layer 216, a liquid electrolyte (generally, referred to as an electrolyte solution) consisting of iodine / iodide ions, tert-butyl pyridine, or the like, as an electrolyte component, into an organic solvent, such as, ethylene carbonate or methoxy acetonitrile, a gel electrolyte which is prepared by adding polyvinylidene fluoride, polyethylene oxide derivative, amino acid derivative, or the like, as a gelling reagent into the liquid electrolyte, or the like may be used.

The stacked body 220 that is formed by sandwiching the electrolyte layer 216 between the working electrode 218 and the counter electrode 219 is enclosed within the casing 221, and the upper and lower surfaces of the stacked body 220 indirectly contact the inner surface of the casing 221. The portion of the casing 221 which at least partially contacts the working electrode 218, i.e., the lid body 225 is made of a material having an optical characteristic of transmitting sunlight, for example, transparent and rigid materials, such as acrylic, polycarbonate, polyvinyl chloride, soda glass, or the like. A material for the other portion of the casing 221, i.e., the housing body 222 that is constructed by the bottom portion 223 and the side portion 224 is not particularly limited, as long as insulation with both of conductive bodies 228 and 229 extending from one of the two electrodes, respectively, to an external circuit to the casing 221 is assured.

The dye-sensitized solar cell 210 is obtained by providing the counter electrode 219 on the inner bottom surface of the housing body 222 constituting the casing 221, overlaying the working electrode 218 on the counter electrode 219 such that the counter electrode 219 contacts the electrolyte layer 21b to form the stacked body 220, placing the lid body 225 constituting the casing 222 over the working electrode 218, and applying a load in the direction orthogonal to the surface of the stacked body 220 from outside of the casing 221 to seal the casing 221.

The sealing of the casing 221 is achieved by, for example, applying pressure or heat to the contacting portion between the side portion 224 of the casing 221 and the lid body 225. However, although the stacked body 220 is enclosed within the casing 221, the heat used in the sealing is not conducted to the stacked body 220 because it is placed distantly (or apart) from the sealing portion of the casing 221. It is possible to employ a structure in which no thermoplastic resin is used by sealing with a laser, for example.

Furthermore, the stacked body 220 that is formed by sandwiching the electrolyte layer 216 between the working electrode 218 and the counter electrode 219 is formed by placing the counter electrode 219 on the working electrode (window electrode) 218 after dropping, applying, or spraying a liquid or gel electrolyte for forming the electrolyte layer 216 on the working electrode (window electrode) 218 to sandwich the liquid or gel electrolyte between the working electrode 218 and the counter electrode 219, and applying a pressure to fill the liquid or gel electrolyte on the porous oxide semiconductor layer, thereby forming the electrolyte layer 216.

Thus, since it is possible to eliminate complex processes that are used conventionally, i.e., forming a hole in the counter electrode 219, injecting the electrolyte solution, and closing the hole, the manufacturing processes can be simplified and labor can be reduced. As a result, low-cost photoelectric conversion elements can be obtained. Furthermore, since it is possible to reduce the distance between the working electrode (window electrode) 218 and the counter electrode 219 as compared to the conventional case, the power generation efficiency of dye-sensitized solar cell can be enhanced. Even further, when silicone oil is used as a space filler 227 between the first substrate 211 constituting the working electrode (window electrode) 218 and the lid body 225 constituting the casing 221, it is possible to eliminate an air layer present between the first substrate 211 and the lid body 225. This is desirable since the transparency is increased.

As described above, in the first embodiment of the present invention, a cell constituting member made of the stacked body 220 that is formed by sandwiching the electrolyte layer 216 between the working electrode 218 and the counter electrode 219 is enclosed within the casing. Thus, since it is possible to seal as a whole the cell constituting member that is made of the stacked body by sealing the casing, a photoelectric conversion element can be obtained which is free from the conventional problem, i.e., influencees on sensitizing dye supported on the dye-sensitized semiconductor electrode caused by the heat that is applied when the electrodes are bonded together. Furthermore, since the cell constituting member made of the stacked body 220 is enclosed within the casing, it is possible to provide a photoelectric conversion element having excellent weather resistance when used for a long time. Even further, the first embodiment of the present invention can contribute to a significant reduction in the manufacturing cost since the stacked body 220 formed by sandwiching the electrolyte layer 216 between the working electrode 218 and the counter electrode 219 can be formed before being enclosed within the casing, and the injection of the liquid or gel electrolyte between the electrodes can be easily performed.

It should be noted that the dye-sensitized solar cell (photoelectric conversion element) 210 has been exemplified having a structure in which a elastic member 236 is provided between the counter electrode 219 and the bottom portion 223 of the casing 221, the space filler 227 is inserted between the working electrode 218 and the lid body 225, and the upper and lower surfaces of the stacked body 220 indirectly contact the inner surface of the casing 221 as a dye-sensitized solar cell (photoelectric conversion element) 210 in this embodiment. However, a dye-sensitized solar cell (photoelectric conversion element) may be used in which no elastic member 226 or space filler 227 is provided, or the stacked body 220 is enclosed within the casing 221 such that the upper and lower surfaces of the stacked body 220 directly contact the inner surface of the casing 221. Furthermore, a structure may be used in which a plurality of stacked bodies 220 are arranged and enclosed within the casing 221.

### Second Embodiment

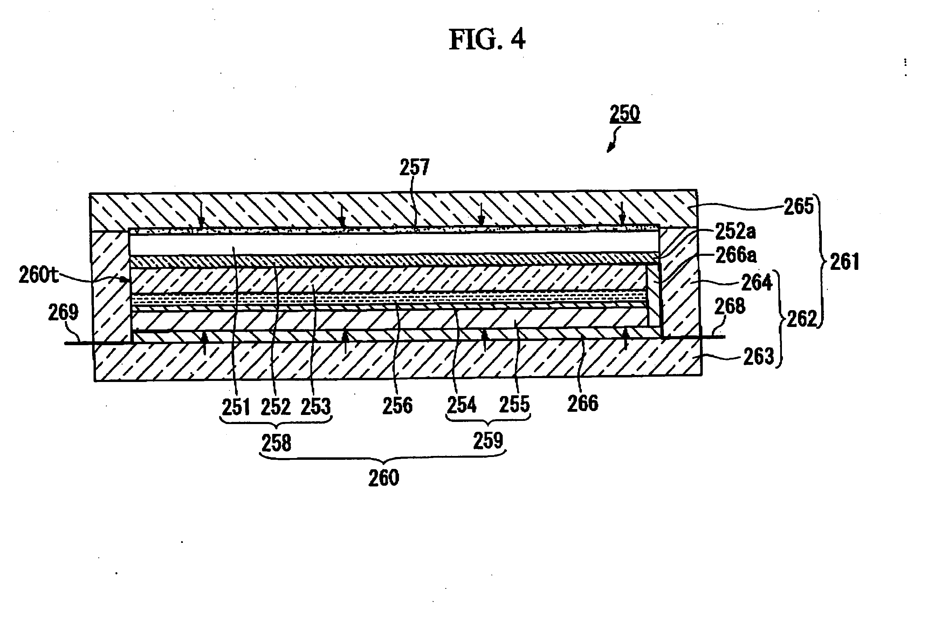

In the above, a photoelectric conversion element 250 according to the first embodiment of the present invention as shown in FIG. 4 has been described. Improvements are made for this photoelectric conversion element 250 mainly from the following two viewpoints.

Firstly, the influence on dye supported on a dye-sensitized semiconductor electrode caused by the heat applied when electrodes are bonded together is reduced, excellent weather resistance when used for a long time is provided, and the injection of an electrolyte solution is facilitated.

In other words, according to the structure shown in FIG. 4, since the heat is not directly applied to two electrodes, i.e., a working electrode 258 and a counter electrode 259, it is possible to eliminate the influence of the heat on the above-described dye. Furthermore, it is possible to form a stacked body 260 formed by sandwiching the electrolyte solution between the working electrode 258 and the counter electrode 259 by dropping an electrolyte solution on a dye-sensitized semiconductor electrode 253 so as to be sandwiched, which is advantageous in that an injection step of the electrolyte solution can be omitted. Furthermore, since the working electrode 258 and the counter electrode 259 are end losed within a casing 261, no direct shock is given from outside, which is also advantageous in that strength against an external force is assured.

Secondly, a sealing can be performed without causing any distortion or breakage of the electrodes constituting substrates and the thicknesses of the substrates can be reduced. In addition, the stability of electric connection can be assured.

More specifically, in the photoelectric conversion element 250, conductive bodies 268 and 269 are provided such that they are routed within the casing 261 without contacting the side surface of the stacked body 260 and one end of each of the conductive bodies is connected to the counter electrode 259 and the working electrode 258, respectively, and the other ends extend outside the casing 251. Thus, the photoelectric conversion element 250 can have electric connection to the outside. Especially, the conductive body 268 one end of which connects the working electrode 258 extends along with the contact surface between an elastic member 266a located between one side surface of the stacked body 260 and the casing 261, and with a transparent conductive film 252 constructing the working electrode 258. Thus, since shortage of contacting between the conductive body 268 and the side surface of the stacked body 260 can be prevented and deformation of the elastic member 266a upon sealing does not affect the conductive body 268, stability of the electrical connection between one end of the conductive body 268 and the working electrode 258 can be achieved

In the manner described above, by forming the working electrode 258 so that it is less affected by the maldistributed pressure in the vicinity of the ends thereof, for atfirst substrate 251 constituting the working electrode 258, it is possible to use an extrentely thin glass substrate having a thickness of 0.3 nm, for example, whereby achieving the reduction in the thickness of the photoelectric conversion element 250.

A second embodiment of the present invention will be described based on examples. It is not intended, however, that the present invention be limited to the examples described below and other structures are possible as long as the above-described effects and effectiveness are fulfilled.

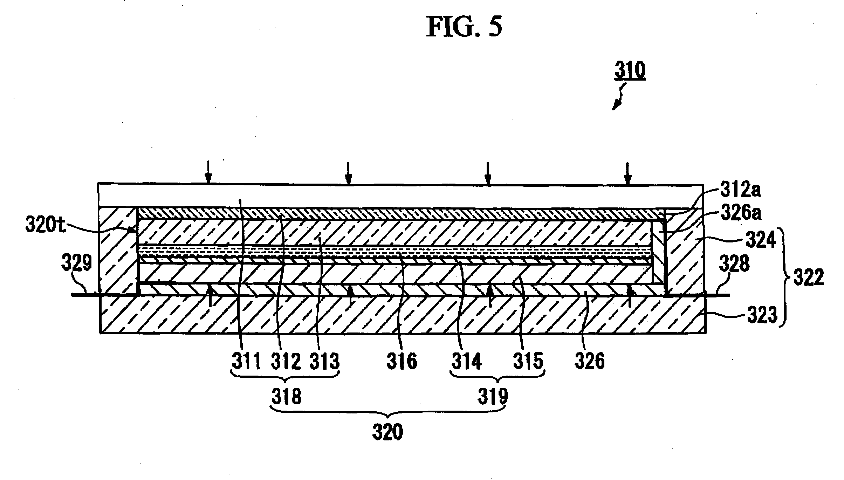

FIG. 5 is a schematic cross-sectional view illustrating an example of a photoelectric conversion element according to the second embodiment of the present invention.

A dye-sensitized solar cell (photoelectric conversion element) 310 includes a working electrode (also referred to as a window electrode) 318 having a porous oxide semiconductor layer (also referred to as an oxide electrode) 313 having a sensitizing dye supported on the surface thereof, a counter electrode 319 provided on the porous oxide semiconductor layer 313 side of the working electrode 318 facing thereto, and an electrolyte layer 316 disposed on at least a part between these two electrodes. The working electrode 318 includes, for example, a first substrate 311 and a transparent conductive film 312 and the oxide electrode 313 provided thereabove in this order. The opposing counter electrode 319 includes, for example, a second substrate 315 and a conductive film 314 disposed thereabove.

A stacked body 320 that is composed of the working electrode 318, the counter electrode 319, and the electrolyte layer 316 sandwiched therebetween functions as a cell constituting member, i.e., a photoelectric conversion element. In the dye-sensitized solar cell 310, the first substrate 311 that is a part of the working electrode 318 functions as one electrode forming the cell, as well as functioning as a lid body constituting a casing In other words, the stacked body 320 is enclosed within a casing that is made of a housing body 322 surrounding the stacked body 320 and the lid body (the working electrode 318), and the lower surface of the stacked body 320 contacts the inner bottom surface of the housing body 322. For the first substrate 311 constituting the working electrode 318 that functions as the lid body of the casing, a material having an optical characteristic of transmitting sunlight may be preferably used.

In the dye-sensitized solar cell 310, the stacked body 320 that is formed by sandwiching the electrolyte layer 316 between the working electrode 318 and the counter electrode 319 is received such that the lower surface thereof contacts the inner bottom surface of the housing body 322, i,e., the inner surface of a bottom portion 323, and the first substrate 311 that is a part of the working electrode 318 functions as the lid body. In other wonds, the stacked body 320 in the dye-sensitized solar cell 310 is constructed such that the upper and lower surfaces thereof are sandwiched between the bottom portion 323 of the housing body 322 constituting the casing and the first substrate 311 that also functions as the lid body.

Accordingly, it is possible to seal as a whole the cell constituting member that is made of the stacked body 320 by placing the counter electrode 319 such that it directly or indirectly contacts the inner bottom surface of the housing body 322, i.e., the inner surface of the bottom portion 323, constituting the casing, overlaying the working electrode 318 on the counter electrode 319 contacting the-electrolyte layer 316 thereon to form the stacked body 320, thereby the first substrate 311 that is a part of the working electrode 318 becomes the lid body of the casing, and sealing at a portion where the first substrate 311 of the working electrode 318 contacts a side portion 324 of the housing body 322 by laser method.

In the photoelectric conversion element 310 employing this structure, since it is possible to utilize the stacked body 320 that is formed by sandwiching the electrolyte layer 316 between the working electrode 318 and the counter electrode 319, a liquid or gel electrolyte can be filled on one of the electrodes and the other electrode can be placed thereon, whereby forming the stacked body, for example. In this process, the electrolyte solution sandwiched between the electrodes does not leak from the spacing between the electrodes due to capillary action. Accordingly, according to the second embodiment of the present invention, since it is possible to omit the injection step of an electrolyte solution, which conventionally requires much time, the second embodiment of the present invention contributes to providing low-cost photoelectric conversion elements.

Furthermore, in the above-described photoelectric conversion element 310; for the first substrate constituting the working electrode, a material having both an optical characteristic to transmit sunlight and a characteristic to resist heat (heat resistance) generated upon receiving laser light is preferred. The optical characteristic to transmit sunlight allows sunlight to reach the stacked body enclosed within the casing. Furthermore, since the resistance to heat prevents generation of curling or the like due to the influence of heat applied upon sealing and assures the inter-electrodes distance, the long-term stability of the power generation characteristic is assured.

It should be noted that the arrows directing to the stacked body 320 shown in FIG. 5 indicate the direction of force applied to the stacked body 320 when the casing 321 is sealed. It is preferable that an elastic member 326 be provided between the counter electrode 319 and the bottom portion 323 constituting the casing 321 in order to prevent an occurrence of a lateral displacement in the stacked body 320 or seal the stacked body 320 so that the stacked body 320 is securely fixed while maintaining flexibility in the vertical direction when an external force is applied to the stacked body 320 in such a direction.

The provision of the elastic member 326 is desirable since the upper and lower electrodes reduce the relative positional displacement in the direction of the surface thereof, the shape stability against an external force is improved, and shock resistance is provided.

Furthermore, in the dye-sensitized solar cell 310, a configuration is employed in which conductive bodies 328 and 329 are provided such that they are routed within the casing that is constituted from a lid body having the first substrate 311 and the housing body 322 without contacting the side surface of the stacked body 320 and one end of each of the conductive bodies is connected to the counter electrode 319 and the working electrode 318, respectively, and the other ends extend outside the casing 321.

In this structure, it is possible to meet various installation requirements according to an external circuit system since the other ends of the conductive bodies 328 and 329 used for connecting to the external circuit that is not shown can be flexibly led outside the casing 321 from anywhere.

As for the conductive body 328 in which the one end thereof is connected to the working electrode 318 and the other end extends outside the casing, it may be provided in a manner in which the above-described elastic member 326a is inserted between each side surface of the oxide electrode 313, the conductive film 314, and the second substrate 315 constituting a part of the stacked body 320 and the conductive body 328, as shown in FIG. 5, for example, so that it is routed within the casing 320 without contacting the side surface of the stacked body 220. By this structure, the conductive bodies 328 and 329 are provided such that they are routed within the inside of the first substrate 311 of the working electrode 318 constituting the lid body of the casing without contacting each side surface of the oxide electrode 313, the conductive film 314, and the second substrate 315 constituting apart of the stacked body 320 and one end of each of the conductive bodies is connected to the counter electrode 319 and the working electrode 318, respectively, and the other ends extend outside the casing, Thus, the photoelectric conversion element 310 can have an electric connection to the outside.

Especially, in the photoelectric conversion element 310, the conductive body 328 one end of which is connected to the working electrode 318 is positioned so that it extends along the contact surface between the elastic member 326a positioned between each side surface of the oxide electrode 313, the conductive film 314, and the second substrate 315 constituting a part of the stacked body 320 and the conductive body 328, and an edge portion 312a of transparent conductive film 312 constituting the working electrode 318. This structure prevents shortage occurring when the conductive body 328 contacts the oxide electrode 313 constituting a part of the stacked body 320 and the side surface of the conductive film 314. Furthermore, even when the elastic member 326a shrinks and deforms upon sealing, the conductive body 328 is rarely affected significantly since it does not route within the elastic member 326a and is located on the contact surface between the edge 312a of the transparent conductive film 312 and the elastic member 326a. Thus, since the electrical connection between the one end of the conductive body 328 and the transparent conductive film 312 constituting the working electrode 318 is maintained to be quite stable, an improvement in this electrical connection provides long-term stability of the output characteristic of the photoelectric conversion element.

Furthermore, in the photoelectric conversion element 310, an arrangement is made such that the side portion 324 of the casing contacts a side surface 320t of the stacked body 320. By adapting a structure in which no void is defined on the side of the stacked body 320, it is assured that the working electrode 318 remains in contact with the counter electrode 319 not only at the center portion thereof but also in the vicinity of its ends. Accordingly, since the working electrode 318 is subjected to no maldistributed pressure in the vicinity of its ends upon sealing, it is possible to maintain the possibility of deformation, breakage, or the like of the first substrate 311 constituting the working electrode 318 to a low level.

The arrangement in which the casing contacts all of the side surfaces of the stacked body is most preferable. However, an arrangement may be adopted in which the elastic member 326a is provided between the side portion 324 of the casing and each side surface of the oxide electrode 313, the conductive film 314, and the second substrate 315 constituting a part of the stacked body 320 only where the conductive body 328 to which the one end of the working electrode 318 is led to the thickness direction of the stacked body 320. Using a member exhibiting insulating property as the elastic member 326a is preferable since a shortage between the stacked body 320 and the conductive body 328 is prevented. When the elastic member 326a is provided in the vicinity where the conductive body 328 is present such that other side portion 324 of the casing contacts the stacked body 320, it is possible to obtain effects similar to the above-described effects.

A method for manufacturing the photoelectric conversion element according to the second embodiment of the present invention is a method for manufacturing the photoelectric conversion element 310 including a working electrode 318 including a porous oxide semiconductor layer 313 having a sensitizing dye supported on the surface thereof in which a counter electrode 319 provided on the porous oxide semiconductor layer 313 side of the working electrode 318 and facing thereto, and the electrolyte layer 316 provided on at least a part of these two electrodes 318 and 319. The method includes at least the following two steps.

In a first step, the electrolyte layer 316 is formed by filling a liquid or gel electrolyte in the porous oxide semiconductor layer 318 constituting the working electrode 318.

In a second step, the casing is formed by placing the counter electrode 319k such that it contacts directly or indirectly the inner bottom surface of the housing body 322, i.e., the inner surface of the bottom portion 323, constituting the casing, overlaying the working electrode 318 on the counter electrode 319 such that the counter electrode 319 contacts the electrolyte layer 316 to form the stacked body 320, thereby the first substrate 311 that forms the working electrode 318 becomes the lid body of the casing, and sealing at the contact portion between the first substrate 311 that forms the working electrode 318 and a side portion 324 of the housing body 322 by laser method or adhesion method.

With the above-described first step, it is possible to inject the liquid or gel electrolyte by filling it prior to sealing, rather than after sealing. In other words, the first step of the second embodiment of the present invention can solve the problems of conventional manufacturing method relating to injection of an electrolyte solution. More specifically, one problem is that upon injecting the electrolyte solution, the electrolyte solution must be injected through a pre-formed inlet between the two electrodes that define a very narrow space after the two electrode plates are fused together to define the shape of cell. Finally, a cap must be placed on the inlet. As a result, the manufacturing processes become complicated. Another problem is that if the viscosity of the electrolyte solution is high, much time and labor is required to inject the electrolyte solution, which incurs an increase in the manufacturing cost.

With the above-described second step, the contact portion between the first substrate 311 that forms the working electrode 318 and a side portion 324 of the housing body 322 is sealed by laser method or adhesion method to form the casing, and the influence on the dye supported on the dye-sensitized semiconductor electrode 313 caused by the conduction of the heat applied upon the sealing is further reduced.

In the following, preferred constituting members will be explained using the above-described photoelectric conversion element 310 as an example.

As the first substrate 311 according to the second embodiment of the present invention, a plate made of a light transparent material is used and anything that is generally used as a transparent substrate of a solar cell may be used, such as one made of glass, polyethylene terephthalate, polyethylene naphthalate, polycarbonate, polyether sulfone, and the like. Although an appropriate one may be selected considering resistance to the electrolyte, a substrate having as high a light transparency as possible for its application is preferred.

It is preferable that the dye-sensitized semiconductor electrode 313 side of the first substrate 311 is imparted with conductivity by forming the transparent conductive film 312 including a layer of metal, carbon, conductive metal oxide, or the like. When a metal layer or a carbon layer is formed as the transparent conductive film 312, it is preferable that a structure that does not significantly reduce the transparency be used and a proper type of metal is selected from the viewpoint of its capability of forming a thin film without reducing the conductivity. As a conductive metal oxide, ITO, SnO₂, fluorine-doped SnO₂, or the like, may be used, for example.

The dye-sensitized semiconductor electrode 313 that is formed by providing the sensitizing dye supported on the semiconductor porous film is provided on the transparent conductive layer 312 located on the first substrate 311. The first substrate 311, the transparent conductive layer 312, and the dye-sensitized semiconductor electrode 313 constitute the working (window electrode) 318. The semiconductor for forming the semiconductor porous film of the dye-sensitized semiconductor electrode 313 is not particularly limited, and anything that can be used to form a porous semiconductor for a solar cell may be used. TiO₂, SnO₂, WO₃, ZnO, Nb₂O₅ or the like, may be used. The porous film may be formed using methods, including, but not limited to, film formation with sol-gel method, electrophoretic-deposition of fine particles, formation of a porous film using foaming agents, coating with a mixture of polymer beads or the like followed by removal of the excess component

The sensitizing dye is not particularly limited, and it is possible to use ruthenium complexes containing a ligand having bipyridine structures, terpyridine structures, and the like; metal containing complexes such as porphyrin and pbthalocyanine; as well as organic dyes such as eosin, rhodamine, and merocyanine. Any dye can be selected without limitation according to the application and the excitation behavior appropriate for the semiconductor used.

Since the second substrate 315 does not necessarily have light transparency, a metal plate may be used, or a plate similar to the plate of the first substrate 311 may be used. An electrode having the conductive film 314 formed on the second substrate 315 is used as the counter electrode 319. As the conductive film 314, although a layer of carbon, platinum, or the like, that is formed by evaporation methods, sputtering methods, or methods in which after applying chloroplatinate, a heat treatment is conducted, may be preferably used, the film is not particularly limited as long as it can function as an electrode.

The electrolyte layer 316 is formed between the above-descnbed working electrode 318 and the counter electrode 319 to form the cell constituting member made of the stacked body 320. The stacked body 320 according to the second embodiment of the present invention is formed by the following method: filling a liquid or gel electrolyte on the porous oxide semiconductor layer 313 constituting the working electrode 318 to form the electrolyte layer 316, overlaying the working electrode 318 on the counter electrode 319 such that the working electrode 318 contacts the electrolyte layer 316 to form the stacked body, and applying a load in the direction orthogonal to the surface of the stacked body 320, as described later.

Thus, since even materials having a high viscosity which are conventionally difficult to inject from an inlet to a narrow space between the electrodes may be used as the electrolyte layer 316 of the second embodiment of the present invention, high-viscosity materials that are made into a gel (quasi-solidified) using an appropriate gelling reagent may be used. However, any material that is conventionally used may be used.

The stacked body 320 that is formed by sandwiching the electrolyte layer 316 between the working electrode 318 and the counter electrode 319 is enclosed within the casing that is constituted by the housing body 322 and the lid body having the first substrate 311, and the lower surface of the stacked body 320 contacts directly or indirectly the inner surface of the bottom portion 323 constituting the housing body 322 of the casing. At least 5 the lid body of casing, i.e., the first substrate 311 constituting the working electrode 318 is made of a material having an optical characteristic of transmitting sunlight, as described above, for example, transparent and rigid materials, such as acrylic, polycarbonate, polyvinyl chloride, soda glass, or the like. A material for the other portion of the casing, i.e., the housing body 322 that is constructed by the bottom portion 323 and the side portion 224 0 is not particularly limited, as long as insulation with both of conductive bodies 328 and 329 extending from one of the two electrodes, respectively, to an external circuit to the casing is assured.

For example, the counter electrode 319 is placed such that it contacts directly the inner bottom surface of the housing body 322 constituting the casing, the working electrode 318 is overlaid on the counter electrode 319 such that the counter electrode 319 contacts the electrolyte layer 316 to form the stacked body 320, and the lid body constituting the casing, i.e., the first substrate 311, is placed over the working electrode 318 becomes the lid body of the casing, and the connecting portion between the lid body and the housing body 322 of the casing by laser irradiation. By this method, it is possible to obtain the dye-sensitized solar cell 310 by enclosing the stacked body forming a cell within the housing body constituting the casing, and sealing the casing as a whole. It is possible to provide the elastic member between the inner bottom surface of the housing body 322 and the counter electrode 319 so that the inner bottom surface of the housing body 322 contacts indirectly the counter electrode 319. Furthermore, sealing may be performed using an adhesive instead of the method using laser irradiation.

The electrolyte solution for forming the electrolyte layer 316 can be filled by being sandwiched by the counter electrode 319 after dropping on the working electrode (window electrode) 318. Thus, since it is possible to eliminate complex processes that are used conventionally, i.e., forming a hole in the counter electrode 319, injecting the electrolyte solution, and closing the hole, the manufacturing processes can be simplified and labor can be reduced. As a result, low-cost photoelectric conversion elements can be obtained,

### Third Embodiment

A third embodiment of the present invention will be described in detail based on 5 examples.

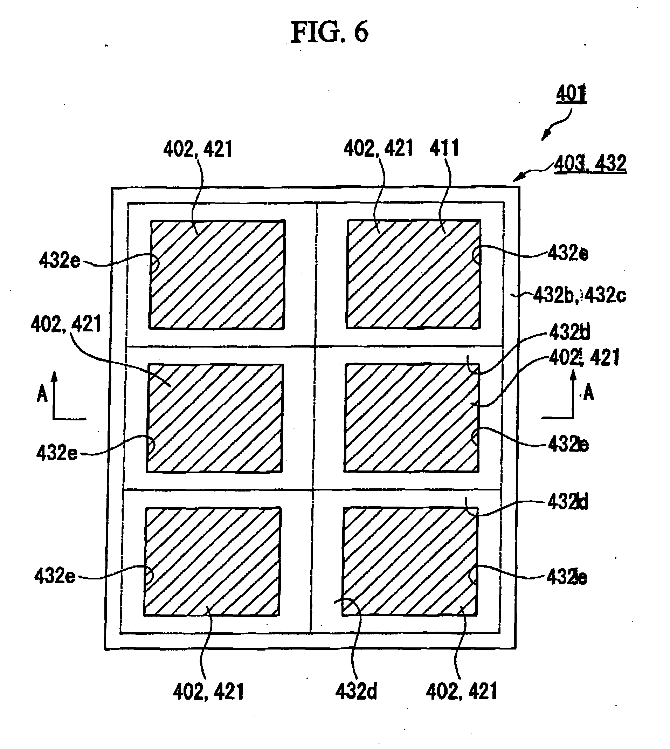

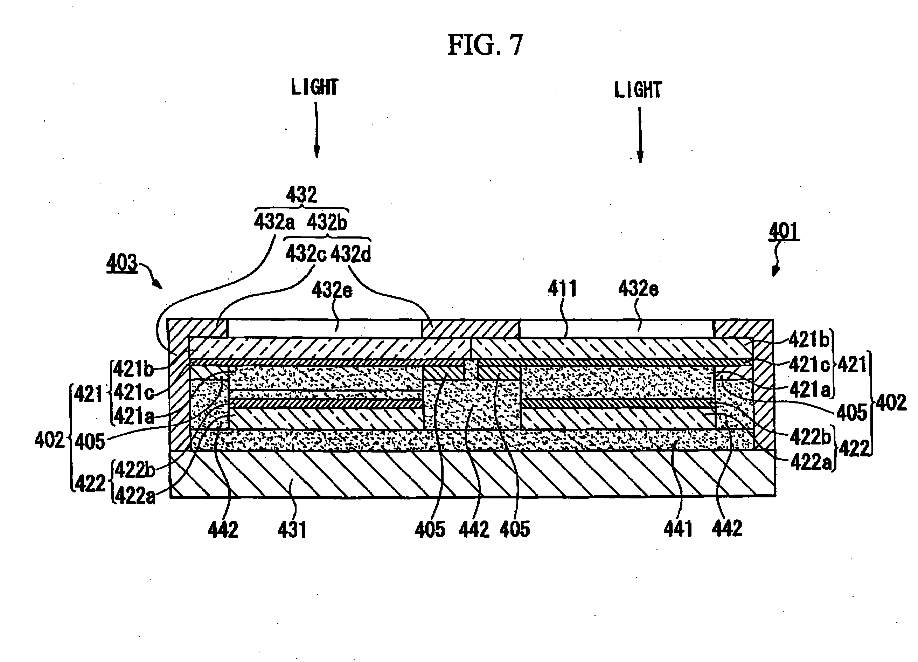

FIG. 6 is a plan view illustrating a dye-sensitized solar cell as an example of a photoelectric conversion element according to a third embodiment of the present invention, and FIG. 7 is a cross-sectional view taken along Line A-A in FIG. 6.

A dye-sensitized solar cell 401 is formed by arranging and sealing a plurality of stacked bodies 402 on a single plane within a casing 403.

The stacked body 402 is formed by stacking a working electrode 421 having a porous oxide semiconductor layer 421 a provided on one surface thereof, a counter electrode 422 provided opposing the porous oxide semiconductor layer 421a, and an electrolyte layer (not shown) between the working electrode 421 and the counter electrode 422 together. The working electrode 421 includes a transparent substrate 421b that is a glass substrate, a light-transmitting plastic film, or the like, a transparent conductive film 421c that is made of tin-doped indium oxide (TTO), fluorine-doped tin oxide (FTO), or the like provided on the transparent substrate 421b, and the porous oxide semiconductor layer 421a provided on the transparent conductive film 421 c.

The porous oxide semiconductor layer 421 a is formed from oxide semiconductor fine particles, such as titanium oxide (TiO₂), zinc oxide (ZnO), tin oxide (SnO₂), niobium oxide (Nb₂O₅), or the like, and a sensitizing dye ruthenium complexes containing a ligand having bipyridine structure, terpyridine structure, and the like absorbed on the surface thereof.

Furthermore, the counter electrode 422 is a conductive substrate and is formed by a thin-film conductive film 422b made of metal, such as platinum, carbon and the like, on a substrate 422a such as a glass substrate.

The electrolyte layer (not shown) sandwiched between the working electrode 421 and the counter electrode 422 is formed from an electrolyte solution in which electrolyte components, such as iodine / iodide ions, tert-butyl pyridine, or the like are dissolved into an organic solvent, such as ethylene carbonate or methoxy acetonitrile, or a gel electrolyte that is prepared by adding polyvinylidene fluoride, polyethylene oxide derivative, amino acid derivative, or the like as a gelling reagent, or the like into the above electrolyte solution.

Most of the electrolyte solution or gel electrolyte constituting the electrolyte layer is impregnated in voids of the porous oxide semiconductor layer of the working electrode 421. By this, the surface of the porous oxide semiconductor layer 421a is coated with the electrolyte solution or the gel electrolyte.

Furthermore, the electrolyte solution or gel electrolyte constituting the electrolyte layer will not leak from the outer periphery portion of the stacked body 402 due to capillary action of the space between particles of oxide semiconductor fine particles constituting the porous oxide semiconductor layer 421a.

In this stacked body 402, when light, such as sunlight, is incident from the transparent substrate 421b side, an electromotive force is generated between the working electrode 421 and the counter electrode 422.

A current collecting wiring portion 405 is provided on the outer periphery portion of the working electrode 421. This current collecting wiring portion 405 is made of a conductive film formed by coating a conductive paste containing a conductive powder and then drying it, a thin film made of a metal, such as platinum, carbon, or the like, and wiring formed by soldering, or the like, on the transparent substrate 421b, and is electrically connected to the transparent conductive film 421c.

It is possible to electrically connect between the stacked body 402 and an external connecting terminal (not shown) provided in the casing 403 via this current collecting wiring portion 405.

Here, an insulation material, such as an elastic member 441 that will be described later or the like is provided between the adjacent transparent conductive films 421 cland current collecting wiring portions 405 of the adjacent stacked bodies 402 so that these transparent conductive films 421c or current collecting wiring portions 405 of the adjacent stacked bodies 402 do not contact electrically.

The casing 403 enclosing the stacked bodys 402 includes a back plate 431 made of a metal plate of stainless steel or the like or a flat plate made of plastic or the like, such as a synthetic resin, and a frame body 432 provided on the outer periphery of this back plate 431.

The frame body 432 includes a side wall portion 432a provided protrudingalmost 5 vertically on the entire outer periphery portion of the back plate 431 and a window frame portion 432b positioned opposing the back plate 431. The window frame portion 482b is formed so as to integrate with the side wall portion 432a from the upper end of the side wall portion 432a toward the stacked body 402 side, and is formed by folding a metal plate of stainless steel or the like, or is made of synthetic resin, such as plastics, for example.

The side wall portion 432a constituting the frame body 432 and the outer periphery portion of the back plate 431 is adhered detachably and fixed by a strippable adhesive, such as epoxy-based adhesive or the like. It is possible to separate the back plate 431 from the side wall portion 432a by inserting a tool having a hard and sharp tip portion into the adhering portion between the back plate 431 and the side wall portion 432a, for example, thereby stripping the adhesive.

A sheet elastic member 441 formed from polyurethane, polyethylene, rubber sponge, or the like is provided on the back plate 431. A plurality of stacked bodies 402 is located by two-dimensional arranging them so that they contact each other on this elastic member 441. In FIG. 6, the chain double-dashed lines indicate boundaries between stacked bodies 402.

These stacked bodies 402 are positioned so that their working electrodes 421 face upward, and light, such as sunlight, that is incident from the window frame portion 432b is absorbed to the porous oxide semiconductor layer 421a, whereby the electromotive force is generated.

The transparent substrates 421b of the working electrodes 421 of these stacked bodies 402 form a light-receiving surface 411 of the dye-sensitized solar cell 401.

It is possible to provide the elastic member 441 or a space filler 442 that is made of silicone oil, for example, between the side wall portion 432a and the stacked body 402 so that no space is formed therebetween.

The window frame portion 432b constituting the frame body 432 includes a framework portion 432c extending from the upper end portion of the side wall portion 432a toward the stacked body 402 and a middle rail portion 432d connected to the framework portion 432c. The framework portion 432c is provided in a region corresponding to the position of the current collecting wiring portion 405 contacting the side wall portion 432a. Furthermore, the middle rail portion 432d is provided in a region corresponding to the position of the current collecting wiring portion 405 in the vicinity of the boundary between adjacent stacked bodies 402.

As an example, in the dye-sensitized solar cell 401 shown in FIG. 6 and FIG. 7, the rectangular stacked bodies 402 are arranged two-dimensionally on the rectangular back plate 431 without any spaces therebetween and the current collecting wiring portions 405 are provided on their outer periphery portions. The middle rail portions 432d are provided and connected to the framework portion 432c in a matrix form in regions corresponding to the positions of the current collecting wiring portions 405 provided on these outer periphery portions of the stacked bodies 402.

The region surrounded by the framework portion 432c and the middle rail portion 432d constituting the window frame portion 432b defines an opening portion 432e, and this opening portion 432e is provided in a region corresponding to the position of the porous oxide semiconductor layer 421 a of the working electrode 421 of the stacked body 402.

As a result, the region corresponding to the position of the porous oxide semiconductor layer 421 a of the transparent substrate 421b of the working electrode 421 is exposed outside via the opening portion 432e of the window frame portion 432b.

Furthermore, the window frame portion 432b comes into contact with the plural stacked bodies 402 arranged on the back plate 431 and the window frame portion 432b presses the stacked bodies 402 to the back plate 431.

It is possible for a sealing member, such as an O-ring, to be provided between the window frame portion 432b and the working electrode 421 of the stacked body 402. By providing such a sealing member, sealing performance between the window frame portion 432b and the working electrode 421 of the stacked body 402 can be enhanced.

An example of a method for sealing the plural stacked bodies 402 within the casing 403 to form the dye-sensitized solar cell 401 will be explained.

The working electrode 421 having the porous oxide semiconductor layer 421a provided thereon and the counter electrode 422 are provided. This working electrode 421 can be manufactured using a conventional method. For example, it can be formed by forming the transparent conductive film 421c on the transparent substrate 421b using sputtering technique or the like, coating a paste containing oxide semiconductor fine particles on the transparent conductive film 421c, and performing heat treatment.

Thereafter, the current collecting wiring portion 405 is formed on the outer periphery portion of the working electrode 421.

An electrolyte solution or gel electrolyte is provided on the surface of the porous oxide semiconductor 421 a of the working electrode 421 or the surface of the counter electrode 422 by dropping/applying. Thereafter, the working electrode 421 and the counter electrode 422 are overlaid while sandwiching the electrolyte solution or the gel electrolyte therebetween to form the stacked body 402.

The elastic member 441 is provided on the back plate 431, and the plural stacked bodies 402 are arranged on this elastic member 441 so that their counter electrodes 422 face the elastic member 441. A lead (not shown) or the like is connected electrically to the counter electrode 422, and this lead is connected electrically to an external connecting terminal (not shown) provided in the casing 403.

It is possible for a space filler 442 to be provided in a region corresponding to the position of the current collecting wiring portion 405.

Next, the frame body 432 having the window frame portion 432b having the framework portion 432c and the middle rail portion 432d in a region corresponding to the position of the current collecting wiring portion 405, and the side wall portion 432a is provided. The window frame portion 432b of the frame body 432 is made to come in contact with the working electrode 421, and the frame body 432 and the outer periphery portion of the back plate 431 are adhered detachably and fixed by a strippable adhesive while the window frame portion 432b presses the stacked body 402 toward the back plate 431.

This pressing force by the window frame portion 432b facilitates infiltration of the electrolyte solution or gel electrolyte to the entire surfaces of the working electrode 421 and the counter electrode 422, as well as infiltrating the electrolyte solution or gel electrolyte to porous inner surfaces of oxide semiconductor of the porous oxide semiconductor layer 421a of the working electrode 421.

The size of the frame body 432 is adjusted beforehand so as to enclose the stacked bodies 402 within the casing 403 without any spaces, and sealing is performed on the entire periphery of the side wall portions 432a of the frame bodies 432 while the stacked bodies 402 are pressed by the window frame portion 432b of the frame body 432 toward the back plate 431.

According to this example, since the window frame portion 432b includes the framework portion 432c provided in a region corresponding to the position of the current collecting wiring portion 405 contacting the side wall portion 432a, and the middle rail portion 432d provided in a region corresponding to the position of the current collecting wiring portion 405 in the vicinity of boundaries between adjacent stacked bodies 402, it is possible to press each stacked body 402 toward the back plate 431 by the framework portion 432c and the middle rail portion 432d while the porous oxide semiconductor layer 421 a of the working electrode 421 is exposed outside via the opening portion 432e surrounded by the framework portion 432c and middle rail portion 432d.

Since the window frame portion 432b presses each stacked body 402 toward the back plate 431 by coming in contact with a region corresponding to the position of the current collecting wiring portion 405 provided on the outer periphery portion of each stacked body 402, this pressing force is applied centering around the outer periphery portion of each stacked body 402.

This facilitates keeping a substantially constant pressing force applied to each stacked body 402, regardless of whether the position in which the stacked body 402 is provided is near the outer periphery portion of the back plate 431 or near the center of the back plate 431. This facilitates maintaining a substantially constant distance between the working electrode 421 and the counter electrode 422 and reduces variation in the power generation efficiency.

Furthermore, since the framework portion 432c is connected to the middle tail portion 432d in the window frame portion 432b, the window frame portion 432b exhibits an excellent torsion strength and is resistant to curling compared to a conventional flat plate lid body having a similar weight, thereby reducing a variation in the pressing force due to deformation of this window frame portion 432b. Thus, the variation in the distance between the working electrode 421 and the counter electrode 422 in each stacked body 402 is reduced, and it is possible to obtain substantial constant power generation efficiency.

In the third embodiment of the present invention, the stacked body 402 is pressed toward the back plate 431 by the window frame portion 432b. It is possible to seal the stacked body 402 within the casing 403 as a whole by overlaying the working electrode 421 and the counter electrode 422 so that the electrolyte solution or the gel electrolyte is sandwiched therebetween and fixing between the frame body 432 and the outer periphery portion of the back plate 431 while the stacked body 402 is pressed toward the back plate 431 by the window frame portion 432b.

Furthermore, as described previously, since the window frame portion 432b is provided in the region corresponding to the position of the current collecting wiring portion 405 which does not contribute to power generation, the porous oxide semiconductor layer 421 a of the working electrode 421 is exposed outside via the opening portion 432e of the window frame portion 432b. Thus, it is possible to increase the area ratio of the porous oxide semiconductor layer (shown by the region of the diagonally shaded areas in RIG. 7,) 421a to the light-receiving surface 411 of the dye-sensitized solar cell 401 and to effectively utilize the light-receiving surface 411 of the dye-sensitized solar cell 401 even further.

Furthermore, by exposing the porous oxide semiconductor layer 421 a of the working electrode 421 outside via the opening portion 432e of the window frame portion 432b, it is possible to make light, such as sunlight, directly incident on the working electrode 421 and be absorbed to the porous oxide semiconductor layer 421 a.

Therefore, unlike a configuration in which light transmits through a lid body and is incident on a working electrode, the strength of light is not reduced before the light is incident on the working electrode 421 and it is possible to further increase the power generation efficiency.

Furthermore, since the window frame portion 432b is provided in the region corresponding to the position of the current collecting wiring portion 405, light, such as sunlight, is not incident on the current collecting wiring portion 405 and it is possible to prevent an increase in the temperature of the current collecting wiring portion 405.

The current collecting wiring portion 405 is usually made of a conductive film formed by coating a conductive paste and then drying it, a thin film made of a metal) such as platinum, carbon, or the like, wiring formed by soldering, or the like, formed on a substrate, such as a glass substrate. Such a current collecting wiring portion 405 may be peeled off from the substrate upon an increase in the temperature since heat stress is generated in the vicinity of the interface with the substrate due to the difference in the thermal expansion coefficient with the substrate.

Therefore, since an increase in the temperature of the current collecting wiring portion 405 is prevented, it is possible to prevent peeling off of the current collecting wiring portion 405 from the substrate due to the increase in the temperature and to obtain excellent long-term stability.

Furthermore, since the elastic member 441 is provided between the back plate 431 and the stacked body 402, it is possible to prevent a lateral displacement of the stacked body 402 when a pressing force pressing the stacked body 402 toward the back plate 43 is applied to the stacked body 402, as well as sealing the stacked body 402 within the casing 403 while the stacked body 402 is fixed securely while ensuring the flexibility in the vertical direction.

Furthermore, by providing the elastic member 441 or the space filler 442, it is possible to prevent an in-plane displacement of the relative position between the working electrode 421 and the counter electrode 422 and to obtain excellent shape stability against an external force or shock resistance.

Furthermore, since the side wall portion 432a constituting the frame body 432 and the outer periphery portion of the back plate 431 is adhered detachably and fixed by a strippable adhesive, it is possible to separate the side wall portion 432a from the back plate 431 by stripping the adhesive. As a result, it is possible to retrieve each stacked body 402 from the back plate 431 after separating the side wall portion 432a from the back plate 431, which allows replacement of stacked bodies 402 and recycling of the back plate 43 or the frame body 432.

The technical scope of the third embodiment of the present invention is not limited to the above-described examples; rather, various changes can be made without departing from the spirit of the third embodiment of the present invention.

For example, the side wall portion 432a and the back plate 431 may be detachably secured by screws or the like.

Furthermore, rather than forming the side wall portion 432a integrally with the window frame portion 432b, the window frame portion 432b may be detachable from the side wall portion 432a. As a result, similar to the above embodiment, it is possible to retrieve each stacked body 402 from the back plate 431 after separating the side wall portion 432a from the window frame portion 432b, which allows replacement of stacked bodies 402 and recycling of the back plate 431 or the frame body 432.

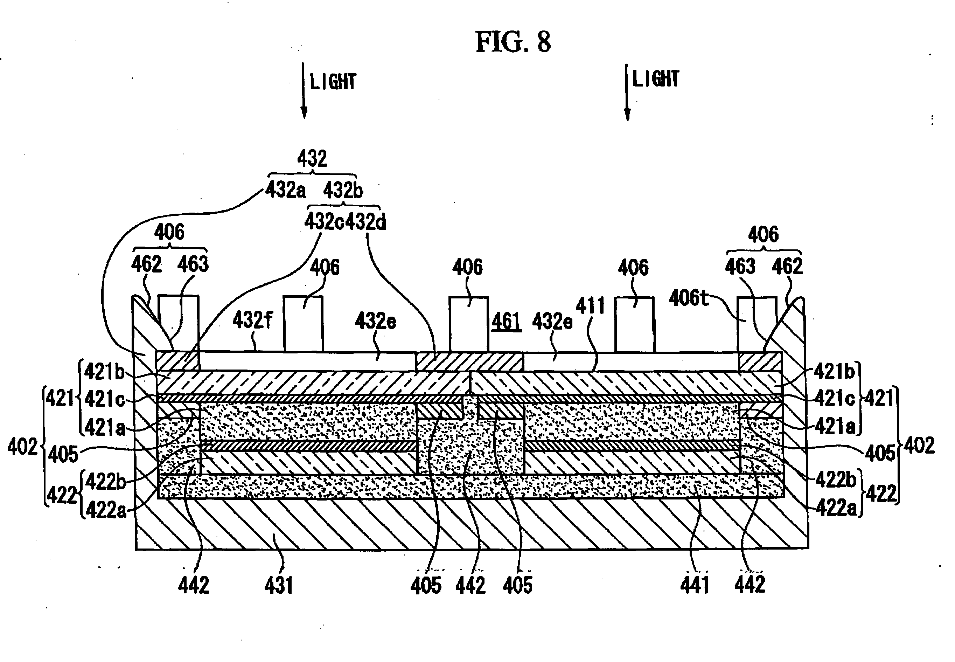

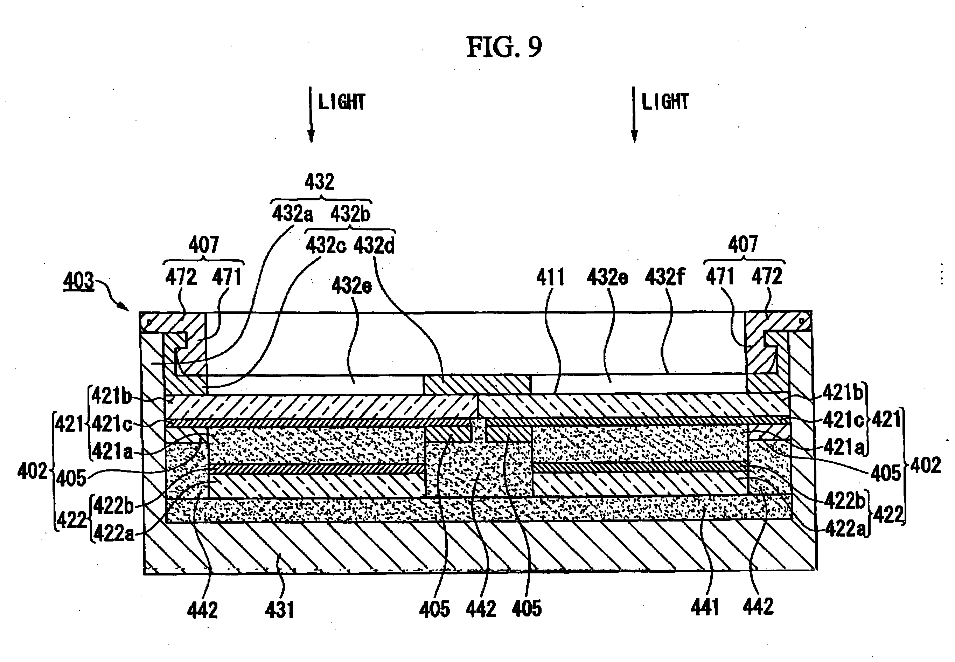

For example, similar to the above embodiment, the side wall portion 432a and the window frame portion 432b are detachably secured together by using a strippable adhesive, screws or the like. Furthermore, it is possible to detachably secure a window frame portion 432b to a side wall portion 432a by using engaging means, such as elastic nails 406, as shown in FIG. 8, or flaps 407 having engaging means, such as engaging nails, as shown in FIG. 9.

FIG. 8 is a cross-sectional view of a dye-sensitized solar cell having, as engaging means, a plurality of elastic nails 406 provided on an upper surface side end 432f of the side wall portion 432a, as another example of the photoelectric conversion element according to the third embodiment of the present invention.

The plural elastic nails 406 are provided on the upper surface side end 432f of the side wall portion 432a so that they protrude therefrom. When the window frame portion 432b is pressed into an inner space 461 surrounded by these plural elastic nails 406 a window frame portion 432b can be inserted into the stacked body 402 placed within the side wall portion 432a while the distances between the plural elastic nails 406 are expantled.

The elastic nails 406 are made of a synthetic resin, such as plastics, and are formed to be integrated with the side wall portion 432a. They protrude from the side surface of a protruding end of the side wall portion 432a and engage with the framework portion 432c of the window frame portion 432b. A sloped surface 462 formed on a protruding end from the side wall portion of this elastic nail 406 smoothly facilitates depressing of the window frame portion 432b into the space 461 surrounded by the plural elastic nails 406 and to depression opening by the plural elastic nails 406 by this depressing, and is shaped to expand the space 461 in a tapered shape in order to smoothly receive the window frame portion 432b.

When the window frame portion 432b is depressed toward the stacked body 402 via the space 461 and the window frame portion 432b moves beyond a tip nail 463 to the stacked body 402 side than the tip nail 463, the tip nail 463 of the elastic nail 406 engages with the upper surface of the framework portion 432c of the window frame portion 432b by means of the elastic restoring force of the elastic nail 406.

In such a situation, the elastic nail 406 plays a role in detachably holding the window frame portion 432b while pressing the window frame portion 432b toward the stacked body 402.

FIG. 9 is a cross-sectional view of a dye-sensitized solar cell having flaps 407 rotatably provided on the upper surface side end 432f of the side wall portion 432a as a further example of the photoelectric conversion element according to the third embodiment of the present invention.

The flaps 407 are rotatably provided on the upper surface side end 432f of the side wall portion 432a. It is possible to hold detachably the window frame portion 432b while pressing the window frame portion 432b toward the stacked body 402 by making engaging means, such as engaging nails 471, provided on these flaps 407 engage with engaged means 408 having an L-shaped cross-section provided on the framework portion 432c of the window frame portion 432b.

The flap 407 is an integral molded piece made of plastic, includes a plate body 472 having the same width as that of the upper surface side end 432f of the side wall portion 432a and engaging means, such as engaging nails 471, formed protruding vertically with respect to the plate body 472 on the end of the plate body 472, and has an L-shaped: cross-section.

The plate body 472 is supported pivotally by a columnar axis portion provided along the upper surface side end 432f of the side wall portion 432a, and a flap 407 can rotate around the axis portion.

Furthermore, the engaged means 408 provided protruding from the framework portion 432c of the window frame portion 432b includes an extending portion 481 protruding from the outer periphery portion of the upper surface of the framework portion 432c and a tip nail 482 having a rectangular cross-section which protrudes from the side surface of a protruding end of the side wall portion 432a and is engaged with the engaging nail 471 of the flap 407. This engaged means 408 is provided on the entire outer periphery portion of the upper surface of the framework portion 432c.

When the flap 407 is rotated toward the stacked body 402 provided on the window frame portion 432b, the tip of the engaging nail 471 of the flap 407 is made to come in contact with the framework portion 432c of the window frame portion 432b and moves toward the engaged means 408 of the window frame portion 432b while pressing the window frame portion 432b toward the back plate 431.

When the engaging nail 471 of the flap 407 and the engaged means 408 of the window frame portion 432b are engaged, the window frame portion 432b is held detachably by the engaging nail 471 of the flap 407 while being pressed toward the stacked body 402.

Since the window frame portion is provided in a region corresponding to a position of the current collecting wiring portion, it is possible to press each stacked body toward the back plate by the window frame portion while the porous oxide semiconductor layer of working electrode is exposed outside via the opening portion. Since the window frame portion presses each stacked body toward the back plate by coming in contact with a region corresponding to the position of the current collecting wiring portion provided on the outer periphery portion of each stacked body, this pressing is exerted mainly around the outer periphery portion of each stacked body.

This facilitates keeping the pressing force applied to each stacked body substantially constant, and to maintain a substantially constant distance between the working electrode and the counter electrode across the entire light-receiving surface of the dye-sensitized solar cell. Thus, variation in the electricity generation efficiency is reduced.

Furthermore, since the framework portion is connected to the middle rail portion in the window frame portion, the window frame portion exhibits an excellent torsion length and is resistant to curling compared to a conventional flat plate lid body having a similar weight, thereby reducing a variation in the pressing force due to deformation of this window frame portion. Thus, the variation in the distance between the working electrode and the counter electrode in each stacked body is reduced, and it is possible to obtain a substantially constant electricity generation efficiency.

Furthermore, since each stacked body is pressed toward the back plate by the window frame portion, it is possible to seal the stacked bodies within the casing as a whole by overlaying the working electrode and the counter electrode so that the electrolyte solution or the gel electrolyte is sandwiched therebetween and fixing the frame body and the outer periphery portion of the back plate while the stacked body is pressed toward the back plate by the window frame portion. Therefore, it is not necessary to use a single cell in which a working electrode and a counter electrode are adhered together using a seal layer unlike the conventional technique, and it is possible to effectively utilize the light-receiving surface of the dye-sensitized solar cell.

Furthermore, since the porous oxide semiconductor layer of the working electrode is exposed outside via the opening portion of the window frame portion, it is possible to increase the area ratio of the porous oxide semiconductor layer to the light-receiving surface of the dye-sensitized solar cell, and to utilize effectively the light-receiving surface of the dye-sensitized solar cell even further.

Furthermore, by exposing the porous oxide semiconductor layer of the working electrode outside via the opening portion of the window frame portion, it is possible to allow light, such as sunlight, directly incident on the working electrode and be absorbed to the porous oxide semiconductor layer. Therefore, unlike a configuration in which light transmits through a lid body and incidents on a working electrode, the strength of light is not reduced before the light incidents on the working electrode and it is possible to further increase the power generation efficiency.

### Fourth Embodiment

In the following, a photoelectric conversion element embodying a fourth embodiment of the present invention will be explained with reference to the drawings.

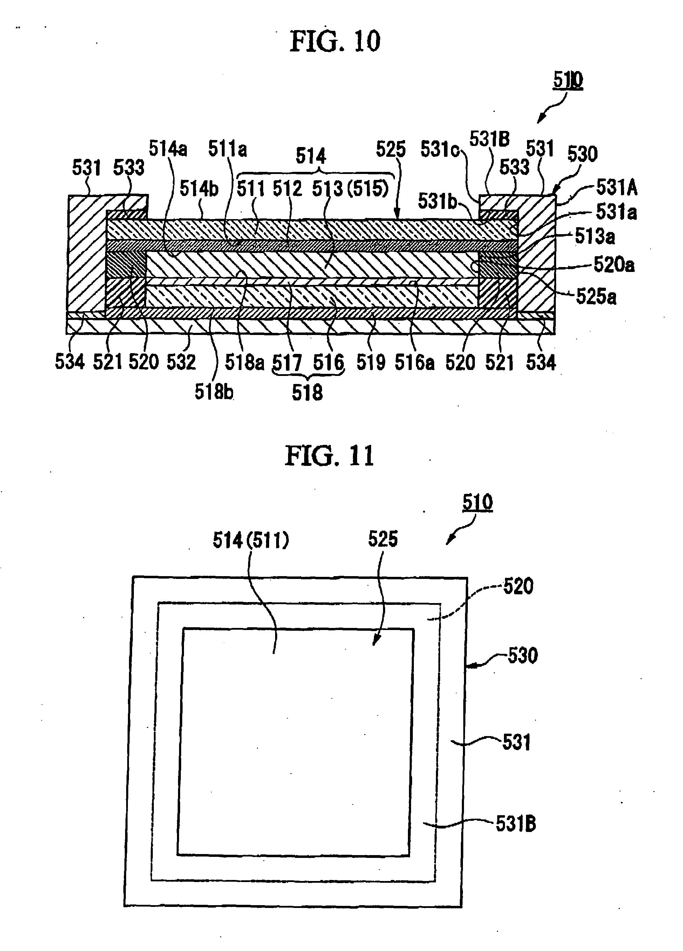

FIG.10 is a schematic cross-sectional view illustrating a dye-sensitized solar cell that is an example of a photoelectric conversion element according to a fourth embodiment of the present invention. FIG. 11 is a schematic plan view illustrating the dye-sensitized solar cell shown in FIG. 10.

In FIG.10 and FIG.11, reference numeral 510 denotes a dye-sensitized solar cell, reference numeral 511 denotes a first substrate, reference numeral 512 denotes a transparent conductive film, reference numeral 513 denotes a porous oxide semiconductor layer, reference numeral 514 denotes a working electrode, reference numeral 515 denotes an electrolyte layer, reference numeral 516 denotes a second substrate, reference numeral 517 denotes a conductive film, reference numeral 518 denotes a counter electrode, reference numeral 519 denotes an elastic member, reference numeral 520 denotes a conductive body, reference numeral 521 denotes a space filler, reference numeral 525 denotes a stacked body, reference numeral 530 denotes a casing, reference numeral 531 denotes a frame body, reference numeral 532 denotes a lid body, reference numeral 533 denotes an adhesive layer, and reference numeral 534 denotes an adhesive layer.

A dye-sensitized solar cell 510 is generally made a working electrode 514 having a porous oxide semiconductor layer 513 provided one surface 514a thereof, a porous oxide semiconductor layer 513 having a sensitizing dye supported thereon, a counter electrode 518 provided opposing the one surface 514a, an electrolyte layer 515 formed between the one surface 514a and a surface 518a of the counter electrode 518 which opposes the one surface 514a (hereinafter referred to as "one surface 518a of the counter electrode 518"), and a conductive body 520 provided on the periphery of the one surface 514a, and a casing 530 enclosing them.

It should be noted that most of the electrolyte forming the electrolyte layer 515 is infiltrated within the void portions of the porous oxide semiconductor layer 513 in this dye-sensitized solar cell 510.

The working electrode 514 includes a first substrate 511, a transparent conductive film 512 and the porous oxide semiconductor layer 513 formed on one surface 511 at thereof in this order. Furthermore, the conductive body 520 is provided on the periphery of the one surface 514a of the working electrode 514 surrounding a side surface 513a of the porous oxide semiconductor layer 513.

The counter electrode 518 includes a second substrate 516 and a conductive film 517 formed on one surface 516a thereof.

In the dye-sensitized solar cell 510, a stacked body 525 formed by sandwiching the electrolyte layer 515 between the working electrode 514 and the counter electrode 518 functions as a photoelectric conversion element.

In the dye-sensitized solar cell 510, the stacked body 525 is enclosed within the casing 530 that has a frame body 531 covering a side surface 525a of the stacked body 525 and a portion of the other surface 514b of the working electrode 514 and a lid body 532 that contacts another surface 518b of the counter electrode 518 and fixes the stacked body 525 to the frame body 531.

The frame body 531 includes a frame portion 531A covering the entire side surface 525a of the stacked body 525 from outside and a pressing portion 531B that is provided protruding from a frame portion 531 A vertically to the frame portion 531A inward (to the direction of the center). The stacked body 525 is enclosed within the casing 530 so that the side surface 525a of the stacked body 525 contacts an inner surface 531a of the frame portion 531A, or the side surface 525a of the stacked body 525 is located in the vicinity of the inner surface 531a of the frame portion 531A. Furthermore, another surface 514b of the working electrode 514 contacts an inner surface 531b of the pressing portion 531B via an adhesive layer 533. Furthermore, the pressing portion 531 B is provided on the other surface 514b of the working electrode 514 covering a region corresponding to a position of the conductive body 520 formed on the one surface 514a of the working electrode 514, and an end surface 531c of the pressing portion 53 1 B and a side surface 520a on the porous oxide semiconductor layer 513 side of the conductive body 520 are present substantially on the same plane.

Furthermore, the lid body 532 contacts the other surface 518b of the counter electrode 518 via an elastic member 519. Furthermore, the lid body 532 is fixed to the frame body 531 via an adhesive layer 534.

It should be noted that the structure in which the pressing portion 531B is provided on the other surface 514b of the working electrode 514 covering a region corresponding to a position of the conductive body 520a formed on the one surface 514a of the working electrode 514 includes not only the structure in which the end surface 531c of the pressing portion 531 B and the side surface 520a on the porous oxide semiconductor layer 513 side of the conductive body 520 are present substantially on the same plane, as shown in FIG. 10, but also the structure in which the end surface 531c of the pressing portion 531B exitsts in the region where the porous oxide semiconductor layer 513 is present, or the structure in which the end surface 531c of the pressing portion 531B is present in the region closer to the frame portion 531A side than the side surface 520a of the conductive body 520.

Furthermore, aspace filler 521 is disposed between the lid body 532 and the conductive body 520 via the elastic member 519 and surrounding the side surface of the counter electrode 518. It should be noted that no space filler may be provided in the photoelectric conversion element according to the fourth embodiment of the present invention.

With such a configuration, the stacked body 525 is enclosed within the casing 530 while the upper and lower surfaces thereof are sandwiched between the pressing portion 531H of the frame body 531 and the lid body 532 and is pressed in the direction orthogonal to the surface of the stacked body. Furthermore, in this configuration, the entire side surface 525a of the stacked body 525 is covered with the frame portion 531A, and the stacked body 525 is sealed in the casing 530 as a whole.

Although the lid body 532 is fixed to the frame body 531 via the adhesive layer 534, it is preferable that the lid body 532 is configured to be easily detachable from the frame body 531 by inserting a thin and hard tool, such as an edge of a razor, between the frame body 531 and the lid body 532. Furthermore, the fixing of the lid body 532 is not limited to adhesion, and it may be performed by screws.

As the first substrate 511, a substrate made of a light transparent material is used and anything that is generally used as a transparent substrate of a solar cell may be used, such as one made of glass, polyethylene terephthalate, polyethylene naphthalate, polycarbonate, polyether sulfone, and the like. Although the first substrate 511 may be suitably selected among them considering resistance to the electrolyte, a substrate having as high a light transparency as possible for its application is preferred.

The transparent conductive film 512 is a thin film made of metal, carbon, conductive metal oxide, or the like, formed on the one surface 511a of the first substrate 511 in order to impart conductivity to the first substrate 511.

When a metal thin film or a carbon thin film is formed as the transparent conductive film 512, a structure that does not significantly degrade the transparency of the first substrate 511 is used. As the conductive metal oxide for forming the transparent conductive film 512, for example, indium-tin oxide (ITO), tin oxide (SnO₂), fluorine-doped tin oxide, or the like, may be used.

The porous oxide semiconductor layer 513 is provided on the transparent conductive film 512 and a sensitizing dye is supported on the surface thereof. The semiconductor for forming the porous oxide semiconductor layer 513 is not particularly limited, and anything that can be used to form a porous semiconductor for a solar cell may be used. As such semiconductors, for example, titanium oxide (TiO₂), tin oxide (SnO₂), tungsten oxide (WO₃), zinc oxide (ZnO), niobium oxide (Nb₂O₅), or the like, may be used

The method for forming the porous oxide semiconductor layer 513 may include, but not limited to, film formation with sol-gel method, electrophoretic-deposition of fine particles, formation of a porous film using foaming agents, coating with a mixture of polymer beads or the like followed by removal of the excess component.

The sensitizing dye is not particularly limited, and it is possible to use ruthenium complexes containing a ligand having bipyridine structures, terpyridine structures, and the like; metal containing complexes such as porphyrin and phthalocyanine; as well as organic dyes such as eosin, rhodamine, and merocyanine. Any dye can be selected among these without limitation according to the application and the excitation behavior appropriate for the semiconductor used.

As the electrolyte layer 515, one formed by infiltrating an electrolyte solution into the porous oxide semiconductor layer 513 or by after infiltrating an electrolyte solution into the porous oxide semiconductor layer 513, making that electrolyte solution into a gel (quasi-solid) using an appropriate gelling reagent to form integrally with the porous oxide semiconductor layer 513 can be used.

As the electrolyte solution, an electrode made by dissolving electrolyte components, such as iodine, iodide ions, tert-butyl pyridine, or the like, into an organic solvent, such as ethylene carbonate, methoxy acetonitrile, or the like, may be used.

As the gelling reagent used for making the electrolyte solution into a gel, polyvinylidene fluoride, polyethylene oxide derivative, amino acid derivative, or the like, are exemplified.

Since the second substrate 516 does not necessarily have light transparency, a metal plate or a synthetic resin plate may be used, as well as a plate similar to the plate of the first substrate 511 may be used.

The conductive film 517 is a thin film made of metal such as platinum, carbon, conductive metal oxide, or the like, formed on the one surface 516a of me second substrate 516 in order to impart conductivity to the second substrate 516. As the conductive film 517, although a layer of carbon, platinum, or the like, that is formed by evaporation methods, sputtering methods, or methods in which after applying chloroplstinate, heat treatment is conducted, may be preferably used, the film is not particularly limited as long as it can function as an electrode.

As the elastic member 519, foamed polyethylene, foamed polyurethane, rubber sponge, or the like, may be used.

In the dye-sensitized solar cell 510, an external force is applied to the stacked body 525 in the direction orthogonal to the surface of the stacked body by sealing the stacked body 525 with the casing 530. By inserting the elastic member 519 between the counter electrode 518 and the lid body 532, it is possible to prevent occurrence of lateral displacement between the working electrode 514 and the counter electrode 518 caused by such an external force. Furthermore, it is possible to fix securely the stacked body 525 to the casing 530 by means of the elastic member 519 while keeping flexibility in the direction orthogonal to the surface of the stacked body.

As the conductive body 520, one in which a circuit is formed with a conductive ink made of silver or the like using screen printing method, or one in which a circuit is formed using soldering may be used. The conductive body 520 is provided on the periphery of the working electrode 514 (surrounding the side surface of the porous oxide semiconductor layer 513) in order to attract efficiently electrons generated within the dye-sensitized solar cell 510.

It is possible to connect electrically the stacked body 525 and an external connecting terminal (not shown) provided in the casing 530 via this conductive body 520.

As the space filler 521, foamed polyethylene, foamed polyrethane, rubber sponge, or the like, may be used.

By inserting the space filler 521 between the lid body 532 and the conductive body 520, it is possible to prevent occurrence of lateral displacement between the working electrode 514 and the counter electrode 518 caused by such an external force generated when sealing the stacked body 525 into the casing 530. Furthermore, it is possible to securely fix the stacked body 525 to the casing 530 by means of the space filler 52; while keeping flexibility in the direction orthogonal to the surface of the stacked body.

The material for forming the frame body 531 and the lid body 532 constituting the casing 530 is not particularly limited, and various metals, ceramics, various synthetic resins, or the like, may be used.

As the adhesive for forming the adhesive layer 533, any adhesives that can bond the first substrate 511 to the frame body 531 may be used, and adhesives that allow detachment of the stacked body 525 from the frame body 531 by application of a certain external force is particularly preferred. As the adhesive for forming the adhesive layer 533, for example, epoxy-based adhesive or the like may be used.

Although adhesives similar to the adhesive for forming the adhesive layer 533 may be used for forming the adhesive layer 534, any adhesives that can bond the lid body 532 to the frame body 531 may be used. Especially adhesives that allow detachment of the lid body 532 from the frame body 531 by application of a certain external force are preferred for forming the adhesive layer 534. As the adhesive for forming the adhesive layer 534, for example, epoxy-based adhesive or the like may be used.

As described above, in the dye-sensitized solar cell 510, since no electrolyte solution is required to be filled between the working electrode 514 and the counter electrode 518 after assembly of the stacked body 520, it is possible to simplify the process. Furthermore, since the dye-sensitized solar cell 510 requires no sealing material made of a thermoplastic resin or the like, it has excellent weather instance, i.e., long-term reliability. Furthermore, since no spacing is required to be defined between the working electrode 514 and the counter electrode 518 in the dye-sensitized solar cell 510, it has excellent power generation efficiency.

Furthermore, in the dye-sensitized solar cell 510, the pressing portion 531B provided on the frame body 531 constituting the casing 530 covers the other surfaces 514b of the working electrode 514 in the region in which the conductive body 520 formed on the one surface 514a is present. Thus, the portion of the working electrode 514 contributing to power generation is not covered by a cover plate or the like and the stacked body 525 is sealed with the casing 530. Accordingly, since the amount of light incident on the portion of the working electrode 514 contributing to power generation is not reduced, the power generation efficiency of the dye-sensitized solar cell 510 is enhanced even further.

Furthermore, in the dye-sensitized solar cell 510, since the conductive body 520 is formed on the periphery of the one surface 514a on the working electrode 514, it is possible to increase the area of the portion of the working electrode 514 contributing to power generation. Thus, the power generation efficiency of the dye-sensitized solar cell 510 is enhanced even further.

Furthermore, in the dye-sensitized solar cell 510, since the stacked body 525 is detachably secured to the frame body 531 via the adhesive layer 533 and the lid body 532 is detachably secured to the frame body 531 via the adhesive layer 534, it is possible to remove the stacked body 525 from the casing 530 for repairing or replacing it with a non-defective one upon a malfunction of the stacked body 525. Furthermore, since it is possible to use the casing 530 repeatedly, the manufacturing cost can be reduced.

Next, an example of the method for manufacturing the photoelectric conversion element according to the fourth embodiment of the present invention will be explained with reference to FIG. 10.

In this example, firstly, the working electrode 514 which has the transparent conductive film 512 and the porous oxide semiconductor layer 513 formed above the one surface 511a of the first substrate 511 in this order is provided using a certain method.

Then, the conductive body 520 is provided on the periphery of the one surface 514a of the working electrode 514.

Then, after an electrolyte solution in which a gelling reagent is added beforehand is dropped on the porous oxide semiconductor layer 513 to make it infiltrate into the porous oxide semiconductor layer 513, this electrolyte solution is made into a gel to form the electrolyte layer 515 integrated with the porous oxide semiconductor layer 513.

Then, the working electrode 514 is placed within the frame body 531 so that the other surface 514b of the working electrode 514 contacts the inner surface 531b of the pressing portion 531B of the frame body 531 via the adhesive layer 533.

Then, the counter electrode 518 is overlaid with the working electrode 513 so that the conductive film 517 is overlaid with the electrolyte layer 515 to form the stacked body 525 formed by sandwiching the electrolyte layer 515 between the working electrode 514 and the counter electrode 518 within the frame body 531.

Then, the space filler 521 is disposed to come in contact with the conductive body 520 surrounding the side surface of the counter electrode 518.

Then, the lid body 532 is disposed to cover the counter electrode 518 via the elastic member 519.

Then, the lid body 532 is fixed to the frame body 531 via the adhesive layer 534 while applying a load in the direction orthogonal to the surface of the stacked body 525 from the outside of the lid body 532 and the stacked body 525 is sealed with the casing 530, whereby obtaining the dye-sensitized solar cell 510.

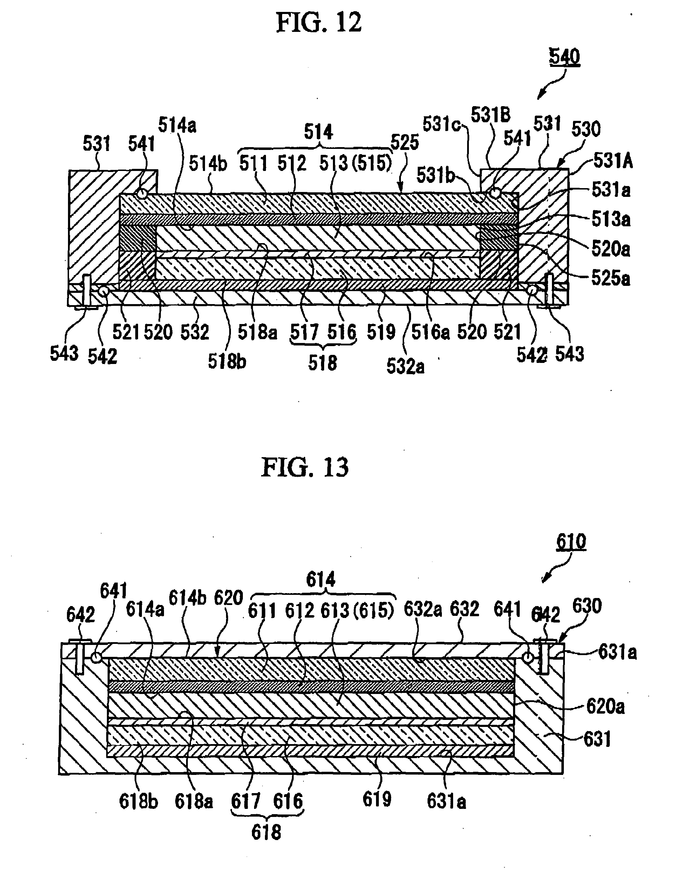

FIG. 12 is a schematic cross-sectional view illustrating a dye-sensitized solar cell that is a second example of a photoelectric conversion element according to the fourth embodiment of the present invention.

This example is different from the above-described first example in the stricture for sealing the stacked body 525 with the casing 530. In FIG. 12, structural elements similar to those in the first example shown in FIG.10 will be referred to by the same reference numeral and a description thereof will be omitted.

In a dye-sensitized solar cell 540, the side surface 525a of the stacked body 525 contacts the inner surface 531a of the frame portion 531A, and the other surface 514b of the working electrode 514 contacts the inner surface 531b of the pressing portion 531H via a sealing member 541.

Furthermore, the lid body 532 contacts the frame body 531 via a sealing member 542. Furthermore, the lid body 532 is fixed to the frame body 531 with screws 543.

It should be noted that fitting portions (not shown) having a groove or the like to fit with the sealing member 541 are preferably provided in the inner surface 531b of the pressing portion 531B of the frame body 531 and the one surface 514a of the working electrode 514 in order to ensure that the stacked body 525 is sealed with the easing:530. Furthermore, fitting portions (not shown) having a groove or the like to fit with the sealing members 542 are preferably provided on the surface contacting the lid body 532 of the frame portion 531A of the frame body 531 and the surface contacting the frame portion 531A of the lid body 532.

As the sealing members 541 and 542, O-rings, gaskets, or the like that are made of elastic material, such as nitrile rubber, silicon rubber, urethane rubber, fluorine rubber, polytetrafluoroethylene, or the like, may be used.

As the screws 543, any screws that can connect and fix the lid body 532 to the frame body 531 may be used.

It should be noted that although the screws 543 are exemplified as means for connecting and fixing the lid body 532 to the frame body 531 in this example, the photoelectric conversion element according to the fourth embodiment of the present invention is not limited to this. In the photoelectric conversion element according to the fourth embodiment of the present invention, means for connecting and fixing the lid body to the frame body include, for example, means for latching a latched portion provided on the frame body to a flap-shaped latching portion rotatably provided on the lid body, and means for clamping the frame portion and the pressing portion of a frame body and the surface of a lid body by a clamping force of a sleeve-shaped spring having a U-shaped cross-section placed outside the casing. Furthermore, the means for latching the latched portion to the latching portion may be a means for fitting a fitting portion into a fitted portion.

By having such a structure, it is possible to easily remove the stacked body 525 from the casing 530 for repairing or replacing it with a non-defective one upon a malfunction of the stacked body 525.

In the photoelectric conversion element according to the fourth embodiment of the present invention, since no electrolyte solution is required to be filled between the working electrode and the counter electrode after assembly of the stacked body, it is possible to simplify the process. Furthermore, since the dye-sensitized solar cell according to the fourth embodiment of the present invention requires no sealing material made of thermoplastic resin or the like, it has excellent weather resistance, i.e., long-term reliability. Furthermore, since no spacing is required to be defined between the working electrode and the counter electrode, the photoelectric conversion element according to the fourth embodiment of the present invention has excellent power generation efficiency. Furthermore, in the photoelectric conversion element according to the fourth embodiment of the present invention, the pressing portion provided on the casing constituting the frame body covers the other surface of the working electrode region in which the conductive body formed on the one surface is present. Thus, the portion of the working electrode contributing to power generation is not covered by a cover plate or the like and the stacked body is sealed by the casing, and the stacked body formed by sandwiching the electrolyte layer between the working electrode and the counter electrode is sealed by the casing. Accordingly, since the amount of light incident on the portion of the working electrode contributing to power generation is not reduced, the power generation efficiency is enhanced even further.

Furthermore, in the photoelectric conversion element according to the fourth embodiment of the present invention, when the conductive body is formed on the periphery of the working electrode, it is possible to increase the area of the portion of the working electrode contributing to power generation and to reduce the resistivity of the substrate. Thus, a photoelectric conversion element having even more excellent power generation efficiency can be realized.

Furthermore, in the photoelectric conversion element according to the fourth embodiment of the present invention, when the frame body and the lid body constituting the casing are secured detachably, it is possible to easily remove the stacked body from the casing for repairing or replacing it with a non-defective one upon a malfunction of the stacked body. Furthermore, since it is possible to use the casing repeatedly, the manufacturing cost can be reduced.

Furthermore, in the photoelectric conversion element according to the fourth embodiment of the present invention, when the elastic member is inserted between the counter electrode and the lid body, it is possible to prevent occurrence of a lateral displacement between the working electrode and the counter electrode when an external force is applied in the direction orthogonal to the surface of the stacked body. Furthermore, it is possible to fix securely the stacked body to the casing by means of the elastic member while keeping flexibility in the direction orthogonal to the surface of the stacked body. Fifth Embodiment

In the following, a photoelectric conversion element embodying a fifth embodiment of the present invention will be explained with reference to the drawings.

FIG.13 is a schematic cross-sectional view illustrating a dye-sensitized solar cell that is an example of a photoelectric conversion element according to the fifth embodiment of the present invention.

In FIG.13, reference numeral 610 denotes a dye-sensitized solar cell, reference numeral 611 denotes a first substrate, reference numeral 612 denotes a transparent conductive film, reference numeral 613 denotes a porous oxide semiconductor layer, reference numeral 614 denotes a working electrode, reference numeral 615 denotes an electrolyte layer, reference numeral 616 denotes a second substrate, reference numeral 617 denotes a conductive film, reference numeral 618 denotes a counter electrode, reference numeral 619 denotes an elastic member, reference numeral 620 denotes a stacked body, reference numeral 630 denotes a casing, reference numeral 631 denotes a main body, reference numeral reference numeral 632 denotes a lid body, reference numeral 641 denotes a sealing member, and reference numeral 642 denotes screws.

A dye-sensitized solar cell 610 is generally made of a working electrode 614 having a porous oxide semiconductor layer 613 provided one surface 614a thereof, the porous oxide semiconductor layer 613 having a sensitizing dye supported thereon, acounter electrode 618 provided opposing the one surface 614a, an electrolyte layer 615 formed between the one surface 614a and a surface 618a of the counter electrode 618 which opposes the one surface 614a (hereinafter referred to as "one surface 618a of the counter electrode 618"), and a casing 630 enclosing them.

It should be noted that most of the electrolyte forming the electrolyte layer 615 is infiltrated within the void portions of the porous oxide semiconductor layer 613 in this dye-sensitized solar cell 610.

The working electrode 614 includes a first substrate 611, and a transparent conductive film 612 and the porous oxide semiconductor layer 613 formed on one surface 611a thereof in this order.

The counter electrode 618 includes a second substrate 616 and a conductive film 616 formed on one surface 616a thereof.

In the dye-sensitized solar cell 610, a stacked body 620 formed by sandwiching the electrolyte layer 615 between the working electrode 614 and the counter electrode 618 functions as a photoelectric conversion element.

In the dye-sensitized solar cell 610, the stacked body 620 is enclosed within the casing 630 that has a main body 631 having a grooved cross-section which covers a side surface 620a of the stacked body 620 and another surface 618b of the counter electrode 618 and a lid body 632 that contacts another surface 614b of the working electrode 614 and fixes the stacked body 620 to the main body 631. Furthermore, the main body 631 contacts the other surface 618b of the counter electrode 618 via a elastic member 619.

Furthermore, the lid body 632 contacts the main body 631 via a sealing member 641. Furthermore, the lid body 632 is fixed to the main body 631 with screws 642.

It should be noted that fitting portions (not shown) having a groove or the like to fit with the sealing member 641 are preferably provided in the surface 631a of the main body contacting the lid body 632 and one surface 632a of the lid body 632 in order to ensure that the stacked body 620 is sealed with the casing 630.

With such a configuration, the stacked body 620 is enclosed within the casing 630 while the upper and lower surfaces thereof are sandwiched between the main body 631 and the lid body 632 and are pressed in the direction orthogonal to the surface of the stacked body. Furthermore, in this configuration, the entire side surface of the stacked body 620a is covered with the main body 631, and the stacked body 620 is sealed in the casing 680 as a whole.

As the first substrate 611, a substrate made of a light transparent material is used and anything that is generally used as a transparent substrate of a solar cell may be used, such as one made of glass, polyethylene terephthalate, polyethylene naphthalate, polycarbonate, polyether sulfone, and the like. Although the first substrate 611 may be suitably selected among them considering resistance to the electrolyte, a substrate having as high a light transparency as possible for its application is preferred,

The transparent conductive film 612 is a thin film made of metal, carbon, conductive metal oxide, or the like, formed on the one surface 611a of the first substrate 611 in order to impart conductivity to the first substrate 611. When a metal thin film or a carbon thin film is formed as the transparent conductive film 612, a structure that does not significantly degrade the transparency of the first substrate 611 is used. As the conductive metal oxide for forming the transparent conductive film 612, for example, indium-tin oxide (ITO), tin oxide (SnO₂), fluorine-doped tin oxide, or the like, may be used.

The porous oxide semiconductor layer 613 is provided on the transparent conductive film 612 and a sensitizing dye is supported on the surface thereof. The semiconductor for forming the porous oxide semiconductor layer 613 is not particularly limited, and anything that can be used to form a porous semiconductor for a solar cell may be used. As such semiconductors, for example, titanium oxide (TiO₂), tin oxide (SiO₂), tungsten oxide (WO₃), zinc oxide (ZnO), niobium oxide (Nb₂O₅), or the like, may be used

The method for forming the porous oxide semiconductor layer 613 may include, but not limited to, film formation with sol-gel method, electrophoretic-deposition of fine particles, formation of a porous film using foaming agents, coating with a mixture of polymer beads or the like followed by removal of the excess component.

The sensitizing dye is not particularly limited, and it is possible to use ruthenium complexes containing a ligand having bipyridine structures, terpyridine structures, and the like; metal containing complexes such as porphyrin and phthalocyanine; as well as organic dyes such as eosin, rhodamine, and merocyanine. Any dye can be selected among these without limitation according to the application and the excitation behavior appropriate for the semiconductor used.

As the electrolyte layer 615, one formed by infiltrating an electrolyte solution into the porous oxide semiconductor layer 613 or by after infiltrating an electrolyte solution into the porous oxide semiconductor layer 613, making that electrolyte solution into a gel (quasi-solid) using an appropriate gelling reagent to form integrally with the porous oxide semiconductor layer 613 can be used.

As the electrolyte solution, an electrode made by dissolving electrolyte components, such as iodine, iodide ions, tert-butyl pyridine, or the like, into an organic solvent, such as ethylene carbonate, methoxy acetonitrile, or the like, may be used.

As the gelling reagent used for making the electrolyte solution into a gel, polyvinylidene fluoride, polyethylene oxide derivative, amino acid derivative, or the like, are exemplified.

Since the second substrate 616 does not necessarily have light transparency, a metal plate or a synthetic resin plate may be used, as well as a plate similar to the plate of the first substrate 611 may be used.

The conductive film 617 is a thin film made of metal such as platinum, carbon, conductive metal oxide, or the like, formed on the one surface 616a of the second substrate 616 in order to impart conductivity to the second substrate 616. As the conductive film 617, although a layer of carbon, platinum, or the like, that is formed by evaporation methods, sputtering methods, or methods in which after applying chloroplatinate, heat treatment is conducted, may be preferably used, the film is not particularly limited as long as it can function as an electrode.

As the elastic member 619, foamed polyethylene, foamed polyurethane, rubber sponge, or the like, may be used.

In the dye-sensitized solar cell 610, an external force is applied to the stacked body 620 in the direction orthogonal to the surface of the stacked body by sealing the stacked body 620 with the casing 630. By inserting the elastic member 619 between the counter electrode 618 and the main body 631, it is possible to prevent occurrence of lateral displacement between the working electrode 614 and the counter electrode 618 caused by such an external force. Furthermore, it is possible to fix securely the stacked body 620 to the casing 630 by means of the elastic member 619 while keeping flexibility in the direction orthogonal to the surface of the stacked body.

The material for forming the main body 631 is not particularly limited, and various metals, ceramics, various synthetic resins, or the like, may be used.

For the lid body 632, a member having an optical characteristic to transmit sunlight is used. The member having an optical characteristic to transmit sunlight is not particularly limited, and examples include, for example, members made of transparent and rigid materials, such as acrylic, polycarbonate, polyvinyl chloride, soda glass.

As the sealing member 641, O-ring% gaskets, or the like that are made of elastic materials, such as nitrile rubber, silicon rubber, urethane rubber, fluorine rubber, polytetrafluoroethylene, or the like, may be used.

As the screws 642, any screws that can connect and fix the lid body 632 to the main body 631 may be used.

It should be noted that although the screws 642 are exemplified as means for connecting and fixing the lid body 632 to the main body 631 in this example, the photoelectric conversion element according to the fifth embodiment of the present invention is not limited to this. In the photoelectric conversion element according to the fifth embodiment of the present invention, means for connecting and fixing the lid body to the frame body include, for example, means for latching a latched portion provided on the frame body to a flap-shaped latching portion rotatably provided on the lid body, and means for clamping the frame portion and the pressing portion of a frame body and the surface of a lid body by a clamping force of a sleeve-shaped spring having a U-shaped cross-section placed outside the casing. Furthermore, the means for latching the latched portion to the latching portion may be a means for fitting a fitting portion into a fitted portion.

As described above, in the dye-sensitized solar cell 610, since no electrolyte solution is required to be filled between the working electrode 614 and the counter electrode 618 after assembly of the stacked body 620, it is possible to simplify the process. Furthermore, since the dye-sensitized solar cell 610 requires no sealing material made of thermoplastic resin or the like, it has excellent weather resistance, i.e., long-term reliability. Furthermore, since no spacing is required to be defined between the working electrode 614 and the counter electrode 618 in the dye-sensitized solar cell 610, it has excellent power generation efficiency.

Furthermore, in the dye-sensitized solar cell 610, since the lid body 632 is detachably secured to the main body 631 via the sealing member 641 and the stacked body 620 is sealed with the casing 630, it is possible to remove the stacked body 620 from the casing 630 for repairing or replacing it with a non-defective one upon a malfunction of the stacked body 620. Furthermore, since it is possible to use the casing 630 repeatedly, the manufacturing cost can be reduced.

Next, an example of the method for manufacturing the photoelectric conversion element according to the fifth embodiment of the present invention will be explained with reference to FIG. 13.

In this example, firstly, the working electrode 611 which has the transparent conductive film 612 and the porous oxide semiconductor layer 613 formed above the one surface 611a of the first substrate 611 in this order is provided using a certain method.

Then, after an electrolyte solution in which a gelling reagent is added before hand is dropped on the porous oxide semiconductor layer 613 to make it infiltrate into the porous oxide semiconductor layer 613, this electrolyte solution is made into a gel to form the electrolyte layer 615 integrated with the porous oxide semiconductor layer 613.

Then, the working electrode 614 is placed within the main body 631 so that the other surface 618b of the counter electrode 618 contacts the inner bottom surface 631a of the main body 631 via the elastic member 619.

Then, the counter electrode 618 is overlaid with the working electrode 614 so that the conductive film 617 is overlaid with the electrolyte layer 615 to form the stacked body 620 formed by sandwiching the electrolyte layer 615 between the working electrode 614 and the counter electrode 618 within the main body 631.

Then, the lid body 632 is disposed covering the other surface 614b of the working electrode 614.

Then, the lid body 632 is fixed to the main body 631 using the screws 642 via the sealing member 641 while applying a load in the direction orthogonal to the surface of the stacked body 620 from the outside of the lid body 632 and the slacked body 620 is sealed with the casing 630, whereby obtaining the dye-sensitized solar cell 610.

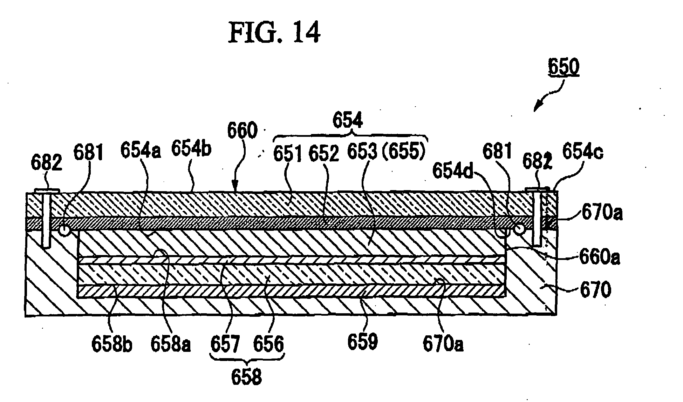

FIG.14 is a schematic cross-sectional view illustrating a dye-sensitized solar cell that is a second example of a photoelectric conversion element according to the fifth embodiment of the present invention.

In FIG. 14, reference numeral 650 denotes a dye-sensitized solar cell, reference numeral 651 denotes a first substrate, reference numeral 652 denotes a transparent conductive film, reference numeral 653 denotes a porous oxide semiconductor layer, reference numeral 654 denotes a working electrode, reference numeral 655 denotes an electrolyte layer, reference numeral 656 denotes a second substrate, reference numeral 657 denotes a conductive film, reference numeral 658 denotes a counter electrode, reference numeral 659 denotes an elastic member, reference numeral 660 denotes a stacked body, reference numeral 670 denotes a casing (also referred to as a "main body"), reference numeral 681 denotes a sealing member, and reference numeral 682 denotes screws.

This dye-sensitized solar cell 650 is generally made of a working electrode 654 having a porous oxide semiconductor layer 653 provided one surface 654a thereof, the porous oxide semiconductor layer 653 having a sensitizing dye supported thereon, a counter electrode 658 provided opposing the one surface 654a, an electrolyte layer 655 formed between the one surface 654a and a surface 658a of the counter electrode 658 which opposes the one surface 654a (hereinafter referred to as "one surface"), and a casing 670 enclosing these.

It should be noted that the electrolyte layer 655 is formed integrally with the porous oxide semiconductor layer 653 in this dye-sensitized solar cell 650.

The working electrode 654 includes a first substrate 651, and a transparent conductive film 652 and the porous oxide semiconductor layer 653 formed on one surface 651 a thereof in this order. Furthermore, no porous oxide semiconductor layer 653 is provided on a periphery 654c of the working electrode 654 which is constructed by the first substrate 651 and the transparent conductive film 652.

The counter electrode 658 includes a second substrate 656 and a conductive film 657 formed on one surface 656a thereof.

In the dye-sensitized solar cell 650, a stacked body 660 formed by sandwiching the electrolyte layer 655 between the working electrode 654 and the counter electrode 658 functions as a photoelectric conversion element.

In the dye-sensitized solar cell 650, the stacked body 660 is enclosed within a main body 670 having a grooved cross-section which covers a side surface 660a of the stacked body 660 and the other surface 658b of the counter electrode 658. Furthermore, the main body 670 contacts another surface 658b of the counter electrode 658 via an elastic member 659.

Furthermore, the periphery 654c of the working electrode 654 contacts directly the main body 670 via a sealing member 681. Furthermore, the periphery 654c of the working electrode 654 is fixed to the main body 670 by screws 682.

It should be noted that fitting portions (not shown) having a groove or the like to fit with the sealing member 681 are preferably provided in a surface 670a contacting the periphery 654c of the main body 670 and a surface 654d of the periphery 654c contacting the main body 670 in order to ensure that the stacked body 660 is sealed with the casing 670.

With such a configuration, the stacked body 660 is enclosed as a whole within the casing 670 while the entire side surfaces of the stacked body 660 are covered with the casing 670 while being pressed in the direction orthogonal to the surface of the stacked body.

As the first substrate 651, one similar to the above-described first substrate 611 may be used.

As the transparent conductive film 652, one similar to the above-described transparent conductive film 612 is provided.

As the semiconductor for forming the porous oxide semiconductor layer 653, semiconductors similar to the semiconductor for forming the above-described porous oxide semiconductor layer 613 may be used.

As the sensitizing dye, one similar to the above-described first example may be used.

As the electrolyte layer 655, one similar to the above-described electrolyte layer 615 is provided.

As the electrolyte solution, one similar to the above-described first example may be used.

As the gelling reagent, one similar to the above-described first example may be used.

As the second substrate 656, one similar to the above-described second substrate 616 may be used.

As the conductive film 657, one similar to the above-described conductive film 617 is provided.

As the elastic member 659, one similar to the above-described elastic member 619 may be used.

Although the material for forming the casing 670 is not particularly limited, materials similar to the material for forming the above-described main body 631 may be used.

As the sealing member 681, one similar to the above-described sealing member 641 may be used.

As the screws 682, ones similar to the above-described screws 642 may be used.

It should be noted that although the screws 682 are exemplified as means for connecting and fixing the working electrode 654 to the casing 670 in this example, the photoelectric conversion element according to the fifth embodiment of the present invention is not limited to this. In the photoelectric conversion element according to the fifth embodiment of the present invention, means for connecting and fixing the lid body to the frame body include, for example, means for latching a latched portion provided on the casing to a flap-shaped latching portion rotatably provided on the working electrode, and means for clamping the surface of the working electrode and the casing by a clamping force of a sleeve-shaped spring having a U-shaped cross-section placed outside them. Furthermore, the means for latching the latched portion to the latching portion may be a means for fitting a fitting portion into a fitted portion.

As described above, in the dye-sensitized solar cell 650, since no electrolyte solution is required to be filled between the working electrode 654 and the counter electrode 658 after assembly of the stacked body 660, it is possible to simplify the process. Furthermore, since the dye-sensitized solar cell 650 requires no sealing material made of thermoplastic resin or the like, it has excellent weather resistance, i.e., long-term reliability. Furthermore, since no spacing is required to be defined between the working electrode 654 and the counter electrode 658 in the dye-sensitized solar cell 650, it has excellent power generation efficiency.

Furthermore, the working electrode 654 functions as a lid of the casing 670, and the portion of the working electrode 654 contributing to power generation is not covered with a cap. Accordingly, since the amount of light incident on the portion of the working electrode contributing to power generation is not reduced, the power generation efficiency of the dye-sensitized solar cell 650 is enhanced even further.

Furthermore, in the dye-sensitized solar cell 650, since the working electrode 654 is fixed detachably to the casing 670 via the sealing member 681 and the working electrode 654 is sealed with the casing 670 while directly contacting the casing 670, it is possible to remove the stacked body 660 from the casing 670 for repairing or replacing it with a non-defective one upon a malfunction of the stacked body 660. Furthermore, since it is possible to use the casing 670 repeatedly, the manufacturing cost can be reduced.

In the photoelectric conversion element according to the fifth embodiment of the present invention, since no electrolyte solution is required to be filled between the working electrode and the counter electrode after assembly of the stacked body, it is possible to simplify the process. Furthermore, since the photoelectric conversion element according to the fifth embodiment of the present invention requires no sealing material made of a thermoplastic resin or the like, it has excellent weather resistance, i.e., long-term reliability. Furthermore, since no spacing is required to be defined between the working electrode and the counter electrode, the photoelectric conversion element according to the fifth embodiment of the present invention has excellent power generation efficiency.

Furthermore, in the photoelectric conversion element according to the fifth embodiment of the present invention, the working electrode functions as a lid of the casing, and the portion of the working electrode contributing to power generation is not covered with a cap. Accordingly, since the amount of light incident on the portion of the working electrode contributing to power generation is not reduced, the power generation efficiency of the dye-sensitized solar cell is enhanced even further. Furthermore, since the working electrode is detachably fixed to the casing and the working electrode is sealed with the casing while directly contacting the casing, it is possible to remove the stacked body from the casing for repairing or replacing it with a non-defective one upon a malfunction of the stacked body. Furthermore, since it is possible to use the main body repeatedly, the manufacturing cost can be reduced.

Furthermore, in the photoelectric conversion element according to the fifth embodiment of the present invention, when the elastic member is inserted between the counter electrode and the casing, it is possible to prevent occurrence of a lateral displacement between the working electrode and the counter electrode when an external force is applied in the direction orthogonal to the surface of the stacked body. Furthermore, it is possible to fix securely the stacked body to the casing by means of the elastic member while keeping flexibility in the direction orthogonal to the surface of the stacked body.

### INDUSTRIAL APPLICABILITY

According to the first embodiment of the present invention, it is possible to provide a photoelectric conversion element that has excellent long-term stability and can be provided at low cost. Since a configuration is employed in which a cell constituting member having a stacked body including an electrolyte layer formed by sandwiching between a working electrode and a counter electrode is enclosed within a casing, a connection with an external circuit is facilitated. Thus, the photoelectric conversion element according to the first embodiment of the present invention significantly reduces the time required for installation.

According to the second embodiment of the present invention, it is possible to provide a photoelectric conversion element that has excellent power generation efficiency and a method for manufacturing the same while retaining an advantage obtained by filling and injecting a liquid or gel electrolyte to a dye-sensitized semiconductor electrode: Accordingly, the second embodiment of the present invention realizes a high output characteristic by increasing the amount of incident light by using a working electrode as a lid body, and contributes to manufacturing of a photoelectric conversion element that has long-term stability of the output characteristic.

According to the third embodiment of the present invention, it is applicable to a photoelectric conversion element having a structure in which a stacked body having a working electrode and a counter electrode overlaid together is sealed within a casing while sandwiching an electrolyte solution or gel electrolyte therebetween, such as a dye-sehsitized solar cell.

According to the fourth and fifth embodiments of the present invention, it is possible to realize a dye-sensitized solar cell that can attract efficiently generated electron while retaining an advantage of facilitating filling with a high viscosity electrolyte or a gel electrolyte. Furthermore, since the amount of incident light on the cell is not reduced and separation from the casing can be easily achieved, it is possible to realize a solar cell that can be easily maintained and recycled and imposes low environmental load.

## Claims

1. A photoelectric conversion element, comprising:
a casing; and
a stacked body enclosed within the casing,
wherein the stacked body comprises:
a working electrode having a porous oxide semiconductor layer having a sensitizing dye supported on a surface thereof;
a counter electrode provided on a side of the porous oxide semiconductor layer of the working electrode facing the working electrode; and
an electrolyte layer disposed on at least a part of which is between the working electrode and the counter electrode, and
wherein an upper surface and a lower surface of the stacked body contacts directly or indirectly an inner surface of the casing, the portion of the casing at least contacting the working electrode being made of a material having an optical characteristic of transmitting sunlight.

2. The photoelectric conversion element as recited in claim 1, further comprising an elastic member provided between the counter electrode and the casing.

3. The photoelectric conversion element as recited in claim 1, further comprising first and second conductive bodies each having one end and another end,
wherein the counter electrode is connected to the one end of the first conductive body so that the first conductive body is routed an inside of the casing without contacting a side surface of the stacked body, and the other end of the first conductive body extends outside of the casing, and
wherein the working electrode is connected to the one end of the second conductive body so that the second conductive body is routed an inside of the casing without contacting the side surface of the stacked body, and the other end of the second conductive body extends outside of the casing.

4. The photoelectric conversion element as recited in claim 3, wherein the other ends of the first and second conductive bodies extend outside of the casing from the side portion of the casing.

5. The photoelectric conversion element as recited in claim 3, wherein the other ends of the first and second conductive bodies extend outside of the casing from the bottom portion of the casing.

6. A method for manufacturing a photoelectric conversion element, comprising the steps of:
providing a casing comprising a housing body having an inner bottom surface and a lid body;
providing a working electrode having a porous oxide semiconductor layer having a sensitizing dye supported on a surface thereof;
forming an electrolyte layer by filling a liquid or gel electrolyte on the porous oxide semiconductor layer of the working electrode;
placing the counter electrode on the inner bottom surface of the housing body of the casing;
overlaying the working electrode on the counter electrode so that the counter electrode contacts the electrolyte layer to form a stacked body;
placing the lid body of the casing on the working electrode over the working electrode; and
applying a load in a direction orthogonal to the surface of the stacked body from an outside of the stacked body to seal the casing.

7. A photoelectric conversion element, comprising:
a housing body having an inner bottom surface; and
a stacked body,
wherein the stacked body comprises:
a working electrode having a porous oxide semiconductor layer having a sensitizing dye supported on a surface thereof;
a counter electrode provided on a side of the porous oxide semiconductor layer of the working electrode facing the working electrode; and
an electrolyte layer disposed on at least a part of which is between the working electrode and the counter electrode, and
wherein the stacked body is enclosed within the housing body so that the counter electrode contacts directly or indirectly the inner bottom surface of the housing body, and the housing body is sealed using the working electrode.

8. The photoelectric conversion element as recited in claim 7, wherein the working electrode comprises a first substrate, and the first substrate is made of a material having both an optical characteristic to transmit sunlight and a resistance to heat.

9. A method for manufacturing a photoelectric conversion element, comprising the steps of:
providing a casing comprising a housing body having an inner bottom surface;
providing a working electrode having a porous oxide semiconductor layer having a sensitizing dye supported on a surface thereof;
forming an electrolyte layer by filling a liquid or gel electrolyte on the porous oxide semiconductor layer of the working electrode;
placing the counter electrode on the inner bottom surface of the housing body of the casing so that the counter electrode contacts directly or indirectly the inner bottom surface of the housing body;
overlaying the working electrode on the counter electrode so that the counter electrode contacts the electrolyte layer to form a stacked body;
placing the working electrode over the casing; and
sealing the working electrode to the housing body using laser method or adhesion method to fabricate the casing.

10. A photoelectric conversion element, comprising:
a casing; and
a plurality of stacked bodies,
wherein the plurality of stacked bodies are sealed within the casing while being arranged, and each of the stacked bodies comprises:
a working electrode;
a counter electrode; and
an electrolyte layer sandwiched between the working electrode and the counter electrode,
wherein the casing comprises a back plate; and a frame body provided on an outer periphery portion of the back plate,
wherein the frame body comprises a side wall portion and a window frame portion, and the window frame portion is provided facing the back plate and presses the stacked body in a direction of the back plate, and
wherein the stacked body comprises a current collecting wiring portion, and the window frame portion is provided in a region corresponding to a position of the current collecting wiring portion of the stacked body.

11. The photoelectric conversion element as recited in claim 10, wherein the side wall portion is detachable from the back plate.

12. The photoelectric conversion element as recited in claim 10, wherein the window frame portion is detachable from the side wall portion.

13. The photoelectric conversion element as recited in claim 10, further comprising an elastic member provided between the stacked body and the back plate.

14. A photoelectric conversion element, comprising:
a stacked body; and
a casing that encloses the stacked body,
wherein the stacked body comprises:
a working electrode;
a counter electrode; and
an electrolyte layer formed between the working electrode and the counter electrode,
wherein the casing comprises a frame body that covers the stacked body and a lid body that fixes the stacked body to the frame body, and the frame body covers a region of the working electrode corresponding to a position where the conductive body is formed.

15. The photoelectric conversion element as recited in claim 14, wherein the conductive body is provided on a periphery of the working electrode.

16. The photoelectric conversion element as recited in claim 14, wherein the lid body is detachably secured to the frame body.

17. The photoelectric conversion element as recited in claim 14, further comprising an elastic member provided between the counter electrode and the lid body.

18. A photoelectric conversion element, comprising:
a stacked body, and
a casing that encloses the stacked body,
wherein the stacked body comprises:
a working electrode;
a counter electrode; and
an electrolyte layer formed between the working electrode and the counter electrode,
wherein the casing comprises a main body that covers the stacked body and a lid body that fixes the stacked body to the main body, and the lid body is detachably secured to the main body.

19. The photoelectric conversion element as recited in claim 18, further comprising an elastic member provided between the counter electrode and the casing.

20. A photoelectric conversion element, comprising:
a stacked body; and
a casing that encloses the stacked body,
wherein the stacked body comprises:
a working electrode;
a counter electrode; and
an electrolyte layer formed between the working electrode and the counter electrode,
wherein the casing is made of a main body that covers the stacked body, and the working electrode is detachably secured to the main body.

21. The photoelectric conversion element as recited in claim 20, further comprising an elastic member provided between the counter electrode and the casing.
